# FASCICULE DE BREVET EUROPEEN

(11) **EP 4 539 638 B1**
(45) Date de publication et mention de la délivrance du brevet: **14.10.2026**
(21) Numéro de dépôt: 25161672.8
(22) Date de dépôt: 12.04.2022
(51) Int. Cl.: H04N 25/46, H04N 25/77, H04N 25/78, H10F 39/00, H04N 25/771, H04N 25/532

(54) **MATRICE DE PIXEL À SOMMATION ANALOGIQUE À OBTURATION GLOBALE**
ANALOGE SUMMIERUNGSPIXELMATRIX MIT GLOBALER DICHTUNG
GLOBAL SHUTTER ANALOG SUMMATION PIXEL ARRAY

(30) Priorité: 15.04.2021 FR 2103903
(43) Date de publication de la demande: 16.04.2025
(62) Numéro(s) de document de la (des) demande(s) initiale(s) en application de l'article 76 CBE: 22167901.2 / 4 075 506
(73) Titulaire: Pyxalis, 38430 Moirans (FR)
(72) Inventeur: GUILLON, Marie, 38120 FONTANIL-CORNILLON (FR)
(74) Mandataire: Atout PI Laplace

(56) Documents cités:
- EP-A1- 3 386 186
- EP-A1- 3 882 973
- WO-A1-2020/100577
- FR-A1- 3 060 250
- US-A1- 2018 166 477
- US-A1- 2020 204 753

## Description

L'invention concerne les capteurs d'images basés sur une matrice de pixels actifs en technologie CMOS.

Ce type de capteurs met à profit les effets photoélectriques dans les matériaux semiconducteurs pour convertir les photons reçus en des signaux électriques permettant de reconstituer l'image captée. Il existe deux grandes familles de capteurs d'images: les capteurs à base de la technologie CCD (Charge - Coupled Device) et les capteurs basés sur la technologie CMOS (Complementary Metal-Oxide-Semiconductor).

Les capteurs CMOS offrent une intégration plus facile dans les circuits intégrés à grande échelle combinée avec un faible coût de fabrication par rapport aux capteurs CCD. Par ailleurs, ils permettent d'obtenir une vitesse de traitement plus élevée avec une consommation énergétique plus faible, ce qui explique l'adoption de cette technologie pour les produits de marché de masse tels que la téléphonie mobile. Il ya a donc un fort interêt à améliorer ces technologies CMOS en leur apportant les avantages de la technologie CCD pour atteindre voire dépasser les performances des technologies CCD faisant référence, tout en maintenant les avantages de la technologies CMOS décrits précedemment.

Le regroupement de pixels (Pixels Binning en anglais) consiste en une sommation des signaux de sortie d'un groupe de pixels adjacents de façon à former un macro-pixel virtuel plus grand composé de n*m pixels, avec au moins un des deux entiers positifs n ou m supérieur ou égal à 2. Cette technique permet d'améliorer la sensibilité du capteur d'image incluant cette caractéristique et ainsi d'améliorer le rapport signal à bruit du capteur d'images en reconstituant le signal d'un groupe de pixels unitaires. La sommation de pixels est utilisée couramment dans les capteurs CCD en se basant sur une addition des charges électriques générées lors du transfert de ces charges. Cependant, dans les capteurs d'images CMOS, l'implémentation de cette caractéristique est plus complexe car l'addition des signaux de sortie des pixels, se fait de façon classique dans le domaine des tensions et non des charges. Dans le domaine des tensions, le signal sommé subit ainsi l'addition quadratique des bruits générés par chaque pixel, bruits associés à leur chaine de lecture respective, ce qui dégrade le rapport signal à bruit du pixel sommé d'un facteur racine de n*m, comparé au rapport signal à bruit d'un pixel équivalent de même taille que le macro pixel non sommé.

Le contexte technologique et économique du domaine des capteurs d'images justifie l'intérêt du développement de solutions pour implémenter la sommation de pixels (Binning) dans les capteurs d'images basés sur une matrice de pixels actifs en technologie CMOS.

De nouvelles applications de capteurs d'images se développent telles que la vision industrielle, la robotique et les voitures autonomes, la vision nocturne. Ces applications demandent une performance supérieure des capteurs d'images à technologie CMOS pour des conditions de faible luminosité et / ou de cibles en mouvements. Ces nouvelles applications nécessitent en plus une imagerie à grande gamme dynamique (en anglais High Dynamic Range - HDR) qui traduit la capacité du capteur à intégrer un grand nombre de charges tout en présentant un faible bruit de lecture relativement aux techniques classiques.

En se basant sur l'explication précédente, on peut déduire que l'implémentation de la fonctionnalité de sommation de pixels dans les capteurs d'image basés sur la technologie CMOS présente un défi technique car un compromis doit être respecté entre les avantages de cette fonctionnalité, à savoir une plus grande sensibilité et un rapport signal à bruit plus élevé, et ses inconvénients liés à un bruit de chaine plus important résultant si cette sommation est effectuée dans le domaine des tensions électriques.

Par ailleurs, les capteurs d'images à technologie CMOS peuvent être utilisés selon deux modes de fonctionnement différents. Un premier mode de fonctionnement est le mode en obturation déroulante, dit « rolling shutter » en anglais, pour lequel les phases d'intégration, de transfert des charges et de lecture sont décalées dans le temps d'une ligne à une autre. Un second mode de fonctionnement est le mode en obturation globale qui permet une capture des photons simultanée dans tous les pixels de la matrice. Ce mode de fonctionnement est plus adapté à des cibles en mouvement. Ainsi, une autre contrainte se pose dans le même contexte et consiste en l'adaptation de la solution de sommation dans le domaine des charges de pixels dans les capteurs d'images CMOS en restant compatible avec un fonctionnement en obturation globale.

Par conséquent, il existe un besoin pour implémenter la fonctionnalité de sommation de pixels dans le domaine des charges dans les capteurs d'images CMOS tout en conservant les avantages apportés par les technologies CMOS utilisant des photodiodes pincées et cela en restant compatible d'un fonctionnement à obturation globale. Ceci afin d'atteindre la performance en rapport signal à bruit d'un pixel de taillle équivalente au macro pixel sommé.

La demande de brevet américaine US 2014/0263964 A1 décrit un capteur d'images CMOS contenant une matrice de pixel capable de réaliser une sommationde pixels en mettant en commun le nœud de détection d'un ensemble de n*n pixels. L'inconvénient de cette solution est que la mise en commun du nœud de détection pour un nombre élevé de pixels fait augmenter la valeur de la capacité sur ce nœud par rapport à la masse globale obtenue via l'accumulation des capacités parasites intrinsèques aux différents transistors MOS formant l'ensemble des pixels. Cela a pour effet une diminution du facteur de conversion du capteur d'image (noté communément CVF pour Conversion Factor en Anglais, et qui représente le gain de conversion des électrons en tension ) mais et par conséquent une augmentation du bruit de chaine ramené en entrée par ce facteur de conversion. Ainsi, cette solution présente l'inconvénient d'une détérioration des performances du capteur d'image pour des conditions de faible luminosité, en terme de ratio signal sur bruit.

La demande de brevet américain US 2014/00218580 A1 décrit un capteur d'images CMOS contenant une matrice de pixel capable de réaliser un sommation de pixels en utilisant une grille de stockage temporaire de charges, de forme dissymétrique, disposée entre la photodiode du premier pixel et la photodiode du deuxième pixel. Cependant, la solution proposée par US 2014/00218580 A1 n'est pas compatible avec un mode de fonctionnement en obturation globale et se limite à un fonctionnement en obturation déroulante.

Pour pallier les limitations des solutions existantes en ce qui concerne l'implémentation de la fonctionnalité de sommation de pixels pour améliorer la sensibilité du capteur d'images CMOS, l'invention propose une structure de matrice de pixels améliorée. La solution proposée consiste en une matrice de pixels réalisée dans la technologie CMOS intégrée dans un capteur d'images et comprenant au moins une sous-matrice de pixel 2*2 disposant de moyens de sommation des charges électriques lui permettant d'effectuer une sommation de pixels dans le domaine des charges.

Cette solution se démarque des solutions de sommation de pixels déjà développées par une capacité de conversion supérieure combinée à un bas niveau de bruit de chaine mais aussi une implémentation physique plus compacte. Cela améliore la performance du capteur d'images dans des conditions de faible luminosité nécessitant une haute sensibilité et un rapport signal sur bruit élevé.

L'invention présente aussi l'avantage de permettre d'associer la fonctionnalité de sommation de pixels avec un fonctionnement en obturation globale offrant ainsi une performance supérieure dans le cas d'une cible en mouvement.

De plus, l'invention reste compatible avec un fonctionnement sans sommation des charges des macro-pixels de la matrice de pixels en adaptant les signaux de contrôle qui commandent la phase de lecture des signaux de sortie de l'ensemble des pixels de la matrice. Cela offre à l'Homme de métier une flexibilité dans l'utilisation de cette fonctionnalité selon les conditions et l'environnement de la capture d'images.

L'invention a pour objet une matrice de pixels de N lignes et M colonnes réalisée dans un substrat semi-conducteur, la matrice comprenant au moins une sous-matrice de quatre pixels adjacents.

Chacun des pixels de la sous-matrice comporte : un ensemble d'un élément à effet photoélectrique pour générer des charges électriques en réponse à une radiation électromagnétique incidente et d'un point mémoire connecté à la sortie de l'élément à effet photoélectrique pour stocker les charges électriques générées, un nœud de détection, une grille de transfert, connectée entre la sortie du point mémoire et le nœud de détection et un étage de sommation. L'étage de sommation est connecté au dit ensemble et étant commun avec un pixel adjacent appartenant à la même ligne de la sous-matrice. Au moins un nœud de détection par sous-matrice est commun à deux pixels adjacents appartenants à la même colonne de la sous-matrice. La matrice de pixels comprend en outre au moins un étage de lecture par sous-matrice, connecté au nœud de détection commun.

Selon un aspect particulier de l'invention, Chacun des éléments à effet photoélectrique est une photodiode pincée.

Selon un aspect particulier de l'invention, chacun des étages de sommation est réalisé par un couple de tranchées d'isolation profondes agencées en parallèles.

Selon un aspect particulier de l'invention, chacun des points mémoires est réalisé par un agencement de tranchées d'isolation profondes. Les tranchées d'isolation profondes forment deux confinements des charges électriques : le premier confinement constitue l'entrée du point mémoire et le second confinement, dopé avec des porteurs de charges à une dose supérieure à celle du premier confinement, constitue le corps du point mémoire.

Selon un aspect particulier de l'invention, chacun des points mémoires est réalisé par un agencement de deux couples de tranchées d'isolation profondes. Les tranchées d'isolation profondes forment deux confinements des charges électriques : le premier confinement constitue l'entrée du point mémoire et il est formé par le premier couple de tranchées disposées parallèlement et séparées par une première distance ; le second confinement constitue le corps du point mémoire et il est formé par le second couple de tranchées disposées parallèlement et séparées par une seconde distance. La première distance est inférieure à la seconde distance.

Selon un aspect particulier de l'invention, l'étage de sommation est connecté entre la sortie de l'élément à effet photoélectrique et la sortie de l'élément à effet photoélectrique du pixel adjacent de la sous-matrice appartenant à la même ligne. De plus, les pixels de la sous-matrice appartenant à la même colonne ont un nœud de détection et un étage de lecture communs.

Selon un aspect particulier de l'invention, les moyens de contrôle dans le mode de réalisation précédent, sont configurés pour appliquer pour chaque pixel d'une même colonne : un potentiel haut sur les tranchées d'isolation profondes formant le point mémoire pour recevoir les charges électriques générées par l'élément à effet photoélectrique; un potentiel bas sur les tranchées d'isolation profondes formant le point mémoire appartenant au pixel adjacent de la sous-matrice appartenant à la même ligne et un potentiel bas sur les tranchées d'isolation profondes formant l'étage de sommation.

Selon un aspect particulier de l'invention, les moyens de contrôle dans le mode de réalisation précédent, sont configurés pour appliquer simultanément pour chaque pixel d'une même colonne : un potentiel haut sur les tranchées d'isolation profondes formant le point mémoire; un potentiel bas sur les tranchées d'isolation profondes formant le point mémoire appartenant au pixel adjacent de la sous-matrice appartenant à la même ligne et un potentiel haut sur les tranchées d'isolation profondes formant l'étage de sommation, pour réaliser une sommation des charges électriques générées par les pixels appartenant à une même ligne de la sous-matrice.

Selon un aspect particulier de l'invention, l'étage de sommation d'un pixel de la sous-matrice est connecté entre la sortie du point mémoire et la sortie du point mémoire du pixel de la sous-matrice appartenant à la même ligne. De plus, les pixels de la sous-matrice appartenant à la même colonne disposent d'un nœud de détection et d'un étage de lecture communs.

Selon un aspect particulier de l'invention, l'étage de sommation d'un pixel de la sous-matrice est connecté entre la sortie du point mémoire et la sortie du point mémoire du pixel de la sous-matrice appartenant à la même colonne. Un premier couple de pixels de la sous-matrice appartenant à la même ligne partage un nœud de détection et un étage de lecture communs.

Un second couple de pixels d'une sous - matrice appartenant à la même colonne sont partagés avec une autre sous-matrice adjacente. Le premier couple de pixels de la sous matrice adjacente est disposé sur une ligne différente du premier couple de pixels de la sous-matrice.

Selon un aspect particulier de l'invention, les moyens de contrôle sont configurés pour appliquer pour chaque pixel de la sous-matrice : un potentiel haut sur les tranchées d'isolation profondes formant le point mémoire pour recevoir les charges électriques générées par les éléments à effet photoélectrique et un potentiel bas sur les tranchées d'isolation profondes formant les étages de sommation.

Selon un aspect particulier de l'invention, les moyens de contrôle sont configurés pour appliquer simultanément sur un couple de pixels adjacents selon une première direction : un potentiel haut sur les tranchées d'isolation profondes formant le point mémoire et un potentiel bas sur les tranchées d'isolation profondes formant le point mémoire appartenant au pixel adjacent de la sous-matrice selon une seconde direction différente de la première direction et un potentiel haut sur les tranchées d'isolation profondes formant les étages de sommation. Cela sert à réaliser une sommation des charges électriques générées par les pixels adjacents selon la seconde direction.

Selon un aspect particulier de l'invention, les moyens de contrôle sont configurés pour appliquer, sur le couple de pixels adjacents selon une première direction, par exemple sur deux pixels de la même colonne, un potentiel haut sur les grilles de transfert pour réaliser une sommation des charges électriques générées dans l'étage de lecture commun.

Selon un aspect particulier de l'invention, laquelle chaque étage de lecture comprend un transistor de réinitialisation connecté au nœud de détection pour réinitialiser le nœud de détection à une tension d'alimentation choisie ; un transistor d'amplification monté en drain commun dont la grille est connectée au nœud de détection et un transistor de sélection connecté à la sortie du transistor amplificateur pour échantillonner le signal de sortie.

L'invention a pour objet notamment un capteur d'images comprenant : une matrice de pixels selon les différents modes de réalisation de l'invention précédents ; un circuit de génération des signaux de commande des pixels ; un circuit d'échantillonnage agencé au pied de chaque colonne de la matrice de pixels connecté à la sortie de l'étage de lecture de chaque pixel de la colonne correspondante et un circuit d'alimentation pour alimenter chaque colonne de la matrice de pixels.

Selon un aspect particulier de l'invention, le circuit d'échantillonnage est un circuit de double échantillonnage corrélé.

Selon un aspect particulier de l'invention, le capteur étant adapté à un fonctionnement en obturation globale. D'autres caractéristiques et avantages de la présente invention apparaîtront mieux à la lecture de la description qui suit en relation aux dessins annexés suivants.
La figure 1 représente un schéma fonctionnel d'une sous-matrice de pixels selon un premier mode de réalisation de l'invention.
La figure 2a représente une vue en coupe d'un mode de réalisation d'un étage de sommation réalisé avec des tranchées d'isolation profondes capacitives face à face.
La figure 2b représente une vue de dessus de l'étage de sommation selon le mode de réalisation de la figure 2a.
La figure 2c représente des diagrammes de potentiels électrostatiques dans l'étage de sommation illustré dans la figure 2a en coupe horizontale.
La figure 3a représente une vue de dessus d'un premier mode de réalisation d'un point mémoire réalisé avec des tranchées d'isolation profondes capacitives face à face.
La figure 3b représente une vue de dessus d'un second mode de réalisation d'un point mémoire réalisé avec des tranchées d'isolation profondes capacitives face à face.
La figure 3c représente des diagrammes de potentiels électrostatiques dans les confinements du point mémoire illustré dans la figure 3a.
La figure 4 représente un exemple de schéma électrique d'un étage de lecture.
La figure 5 représente une vue de dessus d'un exemple d'implémentation physique de la sous-matrice de pixels selon un premier mode de réalisation de l'invention.
La figure 6a représente un chronogramme de fonctionnement de la sous-matrice illustrée à la figure 1 lors d'une sommation des charges électriques.
La figure 6b représente la première étape de la sommation des charges électriques dans une sous-matrice selon le premier mode de réalisation illustré à la figure 1.
La figure 6c représente un diagramme de potentiels électrostatiques illustrant la première étape de la sommation des charges électriques dans une sous-matrice selon le premier mode de réalisation illustré à la figure 1.
La figure 6d représente la deuxième étape de la sommation des charges électriques dans une sous-matrice selon le premier mode de réalisation illustré à la figure 1.
La figure 6e représente un diagramme de potentiels électrostatiques illustrant la deuxième étape de la sommation des charges électriques dans une sous-matrice selon le premier mode de réalisation illustré à la figure 1.
La figure 6f représente la troisième étape de la sommation des charges électriques dans une sous-matrice selon le premier mode de réalisation illustré à la figure 1.
La figure 6g représente un diagramme de potentiels électrostatiques illustrant la troisième étape de la sommation des charges électriques dans une sous-matrice selon le premier mode de réalisation illustré à la figure 1.
La figure 6h représente la quatrième étape de la sommation des charges électriques dans une sous-matrice selon le premier mode de réalisation illustré à la figure 1.
La figure 6i représente un diagramme de potentiels électrostatiques illustrant la quatrième étape de la sommation des charges électriques dans une sous-matrice selon le premier mode de réalisation illustré à la figure 1.
La figure 7 représente un chronogramme de fonctionnement de la sous-matrice illustrée à la figure 1 pour un fonctionnement sans sommation de charges électriques.
La figure 8 représente un schéma fonctionnel d'une sous-matrice de pixels selon un deuxième mode de réalisation de l'invention.
La figure 9a représente un chronogramme de fonctionnement de la sous-matrice illustrée à la figure 8 lors d'une sommation des charges électriques.
La figure 9b représente la première étape d'un fonctionnement avec la sommation des charges électriques dans une sous-matrice selon le deuxième mode de réalisation illustré dans la figure 8.
La figure 9c représente la deuxième étape d'un fonctionnement avec la sommation des charges électriques dans une sous-matrice selon le deuxième mode de réalisation illustré dans la figure 8.
La figure 9d représente la troisième étape d'un fonctionnement avec la sommation des charges électriques dans une sous-matrice selon le deuxième mode de réalisation illustré dans la figure 8.
La figure 9e représente la quatrième étape d'un fonctionnement avec la sommation des charges électriques dans une sous-matrice selon le deuxième mode de réalisation illustré dans la figure 8.
La figure 10 représente un schéma fonctionnel d'une sous-matrice de pixels selon un troisième mode de réalisation de l'invention.
La figure 11 représente un exemple d'implémentation d'une matrice de pixels contenant des sous-matrices de pixels selon le premier mode de réalisation de l'invention illustré à la figure 1.
La figure 12 représente un exemple d'implémentation d'une matrice de pixels contenant des sous-matrices de pixels selon une variante du deuxième mode de réalisation de l'invention illustré à la figure 8.
La figure 13 représente un schéma fonctionnel d'un capteur d'images intégrant une matrice de pixels selon l'un quelconque des modes de réalisation de l'invention.

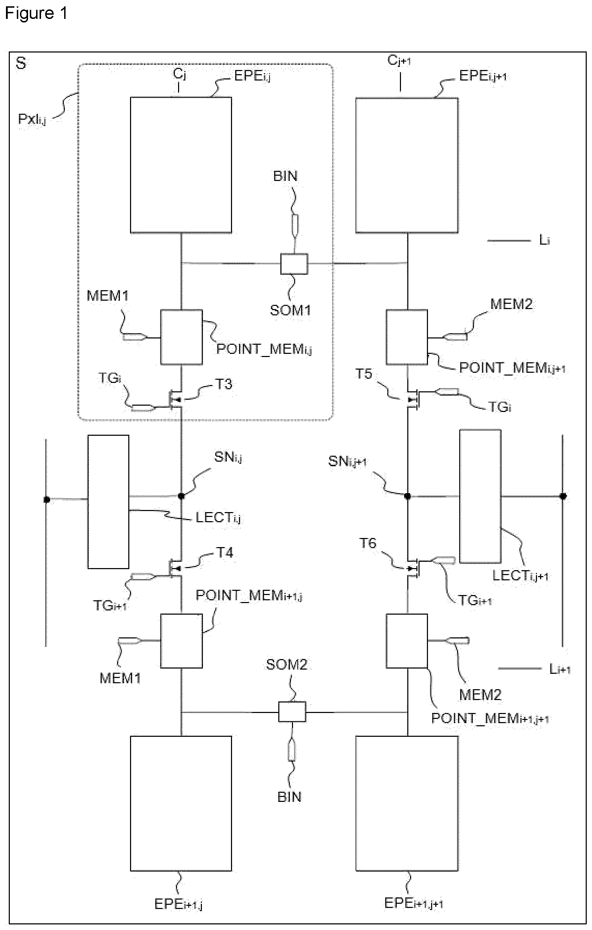

La figure 1 est un schéma fonctionnel représentant l'architecture d'un ensemble de quatre pixels appartenant à une matrice de pixels composée de N lignes Lᵢ de rang i avec i=1 à N et de M colonnes Cⱼ de rang j avec j=1 à M réalisée sur un substrat semi-conducteur. Les quatre pixels sont notés respectivement Pxlᵢⱼ , Pxl_{(i+1),j} , Pxl_{i,(j+1)} et Pxl _{(i+1),(j+1)} selon leurs coordonnées dans la matrice de pixel.

Les quatre pixels Pxl_{i,j} , Pxl_{i+1,j} , Pxl_{i,j+1} et Pxl _{i+1,j+1} sont identiques et forment une sous-matrice symétrique notée S de dimension 2*2 assimilée à un macro-pixel virtuel.

Les quatre pixels de la sous-matrice S disposent chacun de moyens de transfert de charges électriques permettant de réaliser une première opération de sommation des charges électriques générées par les deux pixels (Pxl_{i,j} et Pxl_{i,j+1} par exemple) de la sous-matrice S appartenant à la même ligne et une deuxième opération de sommation des charges électriques générées par les deux pixels (Pxl_{i,j} et Pxl_{i+1,j} par exemple) de la sous-matrice appartenant à la même colonne. La symétrie de la structure de la sous-matrice S offre la possibilité de réaliser la sommation selon une direction d'un pixel unitaire à un autre dans les deux sens.

Pour illustrer l'architecture des pixels Pxl_{i,j} , Pxl_{i+1,j} , Pxl_{i,j+1} et Pxl _{i+1,j+1} qui forment la sous-matrice S, on détaillera dans ce qui suit la composition du pixel Pxl_{i,j} à titre d'exemple.

Le pixel Pxl_{i,j} comporte un élément à effet photoélectrique EPE_{i,j} pour générer et stocker des charges électriques en réponse à une radiation électromagnétique incidente, un point mémoire POINT_MEM_{i,j} connecté à la sortie de l'élément à effet photoélectrique EPE_{i,j} et commandé par le signal MEM1 pour stocker les charges électriques générées ; une grille de transfert T3 commandée par le signal TGᵢ qui connecte un nœud de detection SN_{i,j} commun avec le le pixel adjacent Pxl_{i+1,j} appartenant à la même colonne de la sous-matrice S ; et un étage de sommation SOM1 commandé par le signal BIN commun avec le pixel adjacent Pxl_{i,j+1} appartenant à la même ligne de la sous-matrice S.

De plus, un étage de lecture LECT_{i,j} est connecté au noeud de detection SN_{i,j} qui assure le passage du domaine des charges au domaine des tensions. L'étage de lecture LECT_{i,j} met en forme le signal correspondant aux charges collectées dans le pixel associé. L'étage de lecture LECT_{i,j} est partagé avec le pixel Pxl_{i+1,j} appartenant à la même colonne de la sous-matrice S.

Comme mentionné précédemment, l'élément à effet photoélectrique EPE_{i,j} est utilisé pour générer des charges électriques en réponse à une radiation électromagnétique incidente. Un exemple de réalisation de cet élément est une photodiode pincée. La photodiode est construite généralement par la jonction d'une couche mince dopée P+ avec une zone de diffusion dopée N dans un substrat semi-conducteur dopé P. Lors d'une exposition à un rayonnement électromagnétique, les photons incidents vont interagir avec le substrat semi-conducteur pour générer des paires électron-trou qui seront collectées dans la zone de charge d'espace de la jonction et plus exactement dans la cathode pour le cas des électrons. On parle ici de la phase d'intégration des charges.

L'étage de sommation SOM1 se comporte comme un interrupteur commandé par le signal BIN et reliant les sorties de l'élément à effet photoélectrique EPE_{i,j} avec l'élément à effet photoélectrique EPE_{i,j+1} appartenant à la ligne Lᵢ de la sous-matrice S. L'application d'une impulsion positive sur le signal BIN induit une activation de l'étage de sommation établissant ainsi une connection électrique entre les sorties des deux éléments à effet photoélectrique adjacents EPE_{i,j} et EPE_{i,j+1}. L'établissement de cette connexion permet aux charges électriques générées par l'élément à effet photoélectrique EPE_{i,j} suite à une phase d'integration de migrer vers l'élément à effet photoélectrique adjacent EPE_{i,j+1} et inversement.

Un deuxième étage de sommation SOM2, identique au premier étage de sommation SOM1 et contrôlé par le même signal BIN, est connecté entre les sorties des deux éléments à effet photoélectrique EPE_{i+1,j} et EPE_{i+1,j+1} appartenant tous les deux à la ligne suivante Lᵢ₊₁ de la sous-matrice S pour assurer la même fonction de sommation de charges entre les éléments à effet photoélectrique EPE_{i+1,j} et EPE_{i+1,j+1} et ainsi entre les deux pixels adjacents de la ligne Pxl_{i+1,j} et Pxl_{i+1,j+1}.

Le point mémoire POINT_MEM_{i,j}, commandé par le signal MEM1, est conçu pour stocker les charges électriques collectées dans le substrat de l'élément à effet photoélectrique EPE_{i,j} suite à l'application d'une impulsion sur le signal MEM1. Chacun des pixels de la sous-matrice S contient un point mémoire identique au point mémoire POINT_MEM_{i,j} connecté à la sortie de de l'élément à effet photoélectrique correspondant. L'implémentation des points mémoire POINT_MEM_{i,j}, POINT_MEM_{i,j+1}, POINT_MEM_{i+1,j}, POINT_MEM_{i+1,j+1} assure un fonctionnement en obturation globale du capteur d'images permettant la réalisation de la phase d'intégration des charges électriques de tous les pixels d'une façon simultanée et leurs stockage dans les points mémoires pour déclencher ensuite une lecture séquentielle ligne par ligne des charges stockées.

Les points mémoires POINT_MEM_{i,j} et POINT_MEM_{i+1,j} appartenant aux pixels de la colonne de rang j Cⱼ sont commandés par le même signal MEM1 tandis que les points mémoires POINT_MEM_{i,j+1} et POINT_MEM_{i+1,j+1} appartenant aux pixels de la colonne de rang j+1 Cⱼ₊₁ sont commandés par le même signal MEM2.

La grille de transfert T3 est connectée entre la sortie du point mémoire POINT_MEM_{i,j} et le nœud de détection SN_{i,j}. Cette grille commande un transfert de charges électriques vers le nœud de détection SN_{i,j}. En effet, lorsque le signal externe au pixel TGᵢ connecté à la grille de transfert est à un niveau haut, les charges créées peuvent diffuser vers le nœud de détection SN_{i,j}. La grille correspond généralement à une grille en poly- silicium connectée au nœud de détection SN_{i,j} qui est une zone de diffusion flottante de type N. On parle ici de la phase de transfert des charges vers le nœud de détection et ainsi vers l'entrée de l'étage de lecture LECTᵢⱼ.

Par symétrie, les grilles de transfert T5, T6 et T4 appartiennent respectivement aux pixels Pxl_{i,j+1} , Pxl_{i+1,j+1} et Pxl_{i+1,j}. Le signal de contrôle TGᵢ est adressé en ligne sur les grilles de transfert T3 et T5 appartenant à la ligne de rang i Lᵢ. Le signal de contrôle TGᵢ₊₁ est partagé entre les grilles de transfert T4 et T6 appartenant à la ligne de rang i+1 Lᵢ₊₁. Puisque le nœud de détection SN_{i,j} est commun entre les pixels Pxl_{i,j} et Pxl_{i+1,j},l'activation simultanée des deux grilles de transfert T4 et T3 permet d'accumuler les charges électriques provenant de ces deux pixels dans le nœud de détection commun SN_{i,j} pour être lus ensuite via l'étage de lecture commun LECT_{i,j}. Cela permet d'effectuer alors une sommation des charges générées par les pixels appartenant à la colonne de rang j Cⱼ.

Par symétrie, la même fonctionnalité de sommation verticale peut être réalisée pour les pixels Pxl_{i,j+1} et Pxl_{i+1,j+1} appartenant à la colonne de rang j+1 Cⱼ₊₁ via l'activation simultanée des grilles de transfert T5 et T6.

Le rôle principal des étages de lecture LECT_{i,j} et LECT_{i,j+1} est l'adaptation des signaux convertis au niveaux des nœuds de détection SN_{i,j} et SN_{i,j+1} pour être propagés dans les colonnes associées. Ils assurent aussi les fonctionnalités de réinitialisation et d'adressage séquentiel lors de la lecture des différents pixels de la matrice.

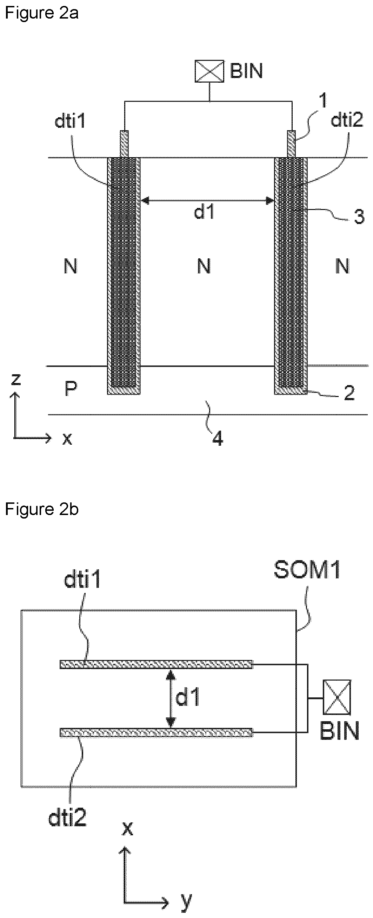

Les figures 2a et 2b décrivent un exemple d'implémentation physique de l'étage de sommation SOM1 ou SOM2 en coupe selon l'axe x et en vue de dessus.

La figure 2b représente une vue de dessus de l'étage de sommation SOM1 ou SOM2 conçu sur un substrat semi-conducteur à l'aide d'un agencement de tranchées d'isolation profondes (communément désignés par DTI acronyme en Anglais de Deep Trench Isolation). Les tranchées d'isolation profondes sont des composants compatibles avec les procédés de fabrication microélectroniques utilisés pour isoler une zone du substrat semi-conducteur pour limiter le courant de fuites dans un circuit intégré par exemple. Il existe une variante de ce type de composants appelée tranchées d'isolation profondes capacitives (communément désignés par CDTI acronyme en Anglais de Capacitive Deep Trench Isolation). Cette variante est utilisée pour illustrer l'invention sans perte de généralité.

Pour bien comprendre la réalisation d'un étage de sommation à l'aide des tranchées d'isolation profondes capacitives *CDTI,* la figure 2a représente une vue en coupe selon l'axe x de la figure 2b d'un couple de tranchées d'isolation profondes capacitives *COTI* notées respectivement dti1 et dti2. La structure d'une tranchée CDTI est fabriquée par la gravure du substrat semi-conducteur 4 pour créer une tranchée profonde de quelques micromètres (entre 3 µm et 6 µm) et d'une largeur de quelques centaines de nanomètres (entre 100 nm et 300 nm). Une couche d'isolant 2, par exemple un oxyde, est créée sur la paroi intérieure de la tranchée par un procédé d'oxydation puis la tranchée est remplie de poly-silicium 3. Un contact métallique 1 est déposé à la surface de la tranchée CDTI fabriquée pour appliquer un potentiel sur la structure obtenue.

En mettant un couple de tranchées CDTI face à face tel que représenté dans les figures 2a et 2b pour dti1 et dti2, en appliquant le même potentiel électrique sur les contacts métalliques de chacune des tranchées et avec un dopage de type N de l'espace entre les deux tranchées CDTI, un puits de potentiel électrostatique est obtenu entre les deux tranchées selon l'axe x pouvant accumuler les charges électriques, à savoir des électrons dans le cas présenté avec un dopage de type N. La profondeur du puits de potentiel obtenu par l'agencement de deux tranchées CDTI face à face dépend de deux facteurs : la distance *d1* entre les deux tranchées et le taux de dopage dans l'espace confiné entre le couple de tranchées dti1 et dti2 L'augmentation de la distance d1 entraine l'augmentation de la profondeur du puits de potentiel créé. Plus le dopage de type N est fort plus la profondeur du puits de potentiel augmente.

Avantageusement, l'utilisation des tranchés CDTI permet de transférer l'intégralité des charges de deux photodiodes adjacentes vers un unique nœud mémoire. Cela n'est pas possible avec l'utilisation d'un transistor pour la sommation. L'utilisation des tranchés CDTI permet d'éliminer le bruit thermique (kTC) ce qui n'est pas faisable avec l'utilisation d'un transistor pour contrôler le flux des charges.

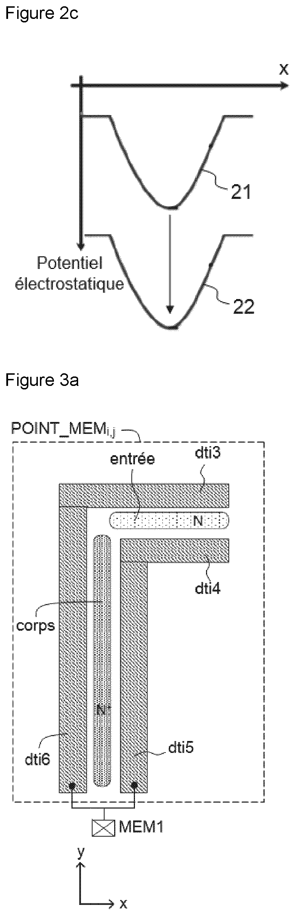

Dans la figure 2c on visualise le puits de potentiel électrostatique 21 selon une coupe selon l'axe x entre les deux tranchées CDTI (dti1 et dti2) qui forment un étage de sommation suite à l'application d'un potentiel bas sur ces tranchées CDTI via le signal BIN. La figure 2c représente également le puits de potentiel électrostatique 21 selon une coupe selon l'axe x entre les deux tranchées CDTI (dti1 et dti2) qui forment un étage de sommation suite à l'application d'un potentiel haut sur ces tranchées CDTI. Selon la convention habituellement choisie, les potentiels croissants sont représentés selon l'axe de potentiel électrostatique allant du haut vers le bas. Un puits de potentiel pour des électrons correspond ainsi à une fonction parabole du potentiel électrostatique qui pointe vers le bas dont le maximum est le fond du puits de potentiel selon la convention adoptée. Plus le maximum du potentiel est haut, plus le puits de potentiel pour des électrons est profond. L'application d'une impulsion positive sur les tranchées CDTI dti1 et dti2 via le signal BIN, décale le niveau du puits de potentiel électrostatique 21 vers la position du puits de potentiel électrostatique 22. Cela correspond à un déplacement d'une barrière de potentiel permettant ainsi aux charges électriques de migrer via l'étage de sommation conçu par la structure décrite précédemment, si le puits électrostatique de la diode est convenablement positionné.

L'implémentation de cette structure de tranchées CDTI dti1 et dti2 entre deux photodiodes correspondant à des éléments à effet photoélectrique permet de contrôler la migration des charges d'un pixel à un autre ce qui constitue une étape dans le processus de sommation des charges dans une sous-matrice S de dimension 2*2.

La figure 3a représente une vue de dessus d'un exemple d'implémentation physique d'un point mémoire utilisé dans les pixels de la sous-matrice S selon l'invention.

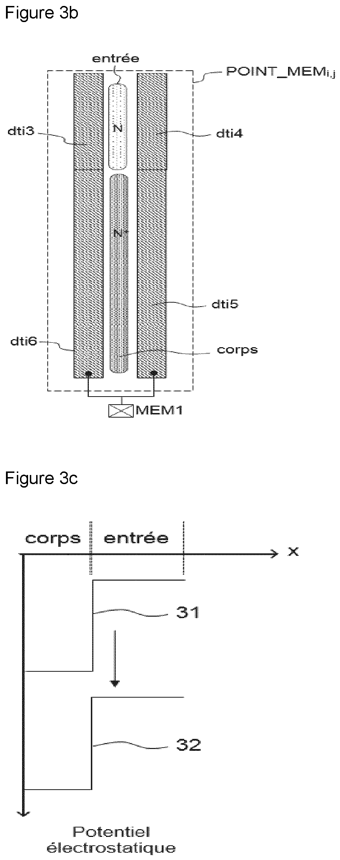

Un point mémoire POINT_MEM_{i,j} tel que décrit dans la figure 3a est composé d'un agencement de deux couples mis en face à face de tranchées CDTI à savoir (dti3, dti4) et (dti5,dti6). Les tranchées d'isolation profondes forment deux confinements des charges électriques selon deux directions perpendiculaires. Le premier confinement constitue l'entrée du point mémoire dopé avec des porteurs de charge de type N et le second confinement, dopé avec une dose supérieure de porteurs de charges pour avoir un dopage de type N+, constitue le corps du point mémoire. L'ensemble des tranchées CDTI qui forment le point mémoire à savoir dti1, dti2, dti3 et dti4 sont contrôlées par le même signal de contrôle MEM1 (ou MEM2). La différence de dopage entre l'entrée du point mémoire et le corps du point mémoire créée une différence de potentiel électrostatique entre les confinements crées par les deux zones et il en résulte le diagramme de potentiel électrostatique 31 représenté à la figure 3c.

Alternativement, il est possible d'implémenter l'entrée du point mémoire dans une direction différente mais non perpendiculaire à celle du corps du point mémoire, tout en gardant la différence de dopage entre les deux régions.

Alternativement, il est possible d'implémenter l'entrée du point mémoire dans la même direction que celle du corps du point mémoire tel que illustré dans la figure 3b, tout en gardant la différence de dose de dopage entre les deux régions.

Alternativement, il est possible de réaliser le point mémoire POINT_MEM_{i,j} constitué d'une entrée et d'un corps en se basant sur une différence de la distance entre les tranchées qui constituent chaque région (entrée et corps) et non une différence de dopage du substrat. En effet, soit d2 la distance entre les tranchées dti3 et dti4 qui forment l'entrée du point mémoire, et soit d3 la distance entre les tranchées dti5 et dt6 qui forment le corps du point mémoire. Nous rappelons que pour un couple de tranchées disposées en face à face, l'augmentation de la distance entre les deux tranchées entraine l'augmentation de la profondeur du puits de potentiel créé entre les deux tranchées. Ainsi, à une dose de dopage équivalente, si la distance d2 séparant les tranchées qui forment l'entrée du point mémoire est inférieure à la distance d3 entre les tranchées qui forment le corps du point mémoire, on obtient le même diagramme de potentiel électrostatique décrit dans la figure 3c. On réalise ainsi un point mémoire à partir des variations géométriques de la structure et non à partir des variations de la dose dopage.

D'une façon similaire au principe expliqué pour les étages de sommation à base de tranchées CDTI, l'application d'un potentiel haut sur les tranchées qui constituent le point mémoire décale la barrière de potentiel 31 vers la position de la barrière illustrée par le diagramme 32 permettant ainsi la migration des charges électriques à travers le confinement de l'entrée du point mémoire qui seront ainsi stockées dans le confinement de la région du corps réalisant ainsi la fonction de mémoire.

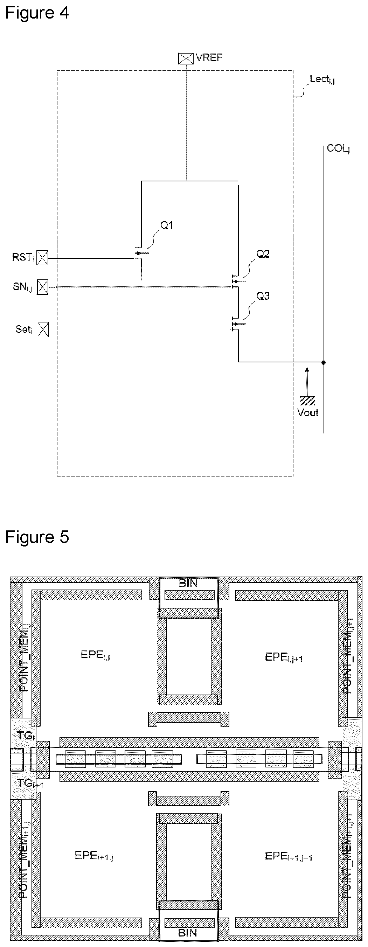

La figure 4 illustre un schéma électrique d'un exemple d'implémentation de l'étage de lecture LECT_{i,j} utilisé dans la sous-matrice S selon l'un des modes de réalisation de l'invention.

L'étage de lecture LECT_{i,j} reçoit deux signaux d'entrée RSTᵢ et SELᵢ communs avec tous les autres étages de lecture de la matrice de pixels appartenant à la même ligne de rang i Lᵢ. L'étage de lecture LECT_{i,j} est aussi alimenté par une tension de référence VREF. L'étage de lecture LECT_{i,j} convertit les charges collectées par le nœud de détection SN_{i,j} en une tension de sortie Vout propagée dans la ligne conductrice COLⱼ.

L'étage de lecture LECT_{i,j} comprend un transistor de réinitialisation Q1 connecté entre le nœud de détection SN_{i,j} et la tension de référence externe VREF pour réinitialiser le nœud de détection et permettre de réaliser un double échantillonnage corrélé à l'échelle globale du capteur d'images.

L'étage de lecture LECT_{i,j} comprend aussi un transistor d'amplification Q2 monté en drain commun pour adapter le signal de sortie à la ligne conductrice de la colonne associée.

L'étage de lecture LECT_{i,j} comprend également un transistor de sélection Q3 connecté à la sortie du transistor d'amplification Q2 pour échantillonner le signal de sortie du transistor d'amplification Q2. Le commutateur de sélection Q3 est contrôlé par un signal de sélection de ligne noté SELᵢ. Lorsque la ligne à laquelle appartient le pixel est choisie pour la lecture, le transistor Q3 est passant, laissant ainsi propager le signal Vout à la sortie de l'étage de lecture dans la colonne via la ligne conductrice COLⱼ.

La figure 5 illustre une vue de dessus d'un exemple d'implémentation physique (Layout en Anglais) de la sous-matrice S selon le premier mode de réalisation décrit à la figure 1. L'homme du métier pourra distinguer les différents composants de la sous-matrice S détaillée dans la description de la figure 1 sur cette vue spécifique qui traduit le masque utilisé lors des différentes étapes de processus de fabrication micro-électronique dans un substrat semi-conducteur.

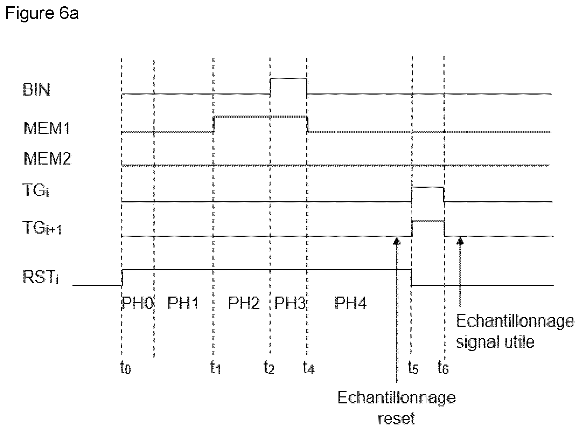

La figure 6a représente un chronogramme de fonctionnement de la sous-matrice illustrée dans la figure 1 avec sommation des charges électriques.

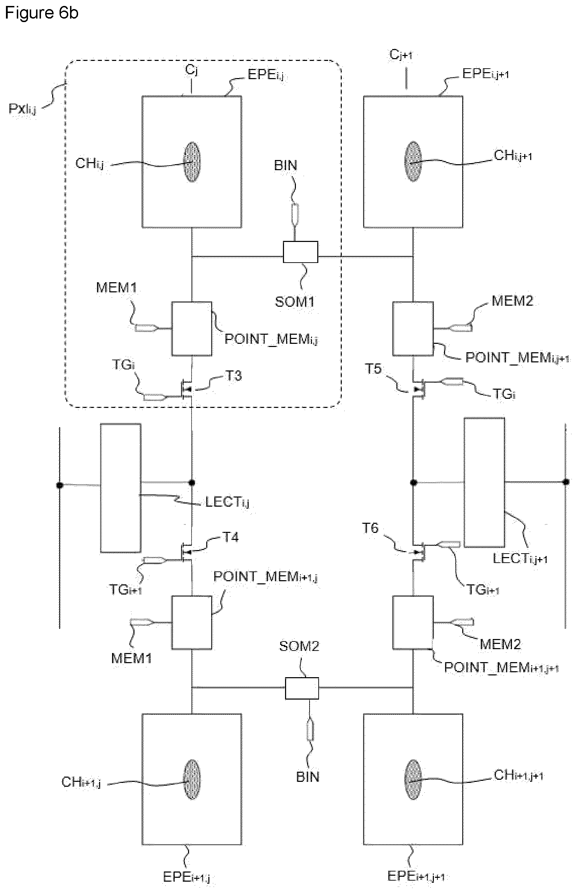

Les figures 6b à 6i illustrent les différentes étapes d'un fonctionnement avec la sommation des charges électriques dans une sous-matrice selon le premier mode de réalisation illustré à la figure 1. Pour chaque étape, on retrace le cheminement des charges électriques générées par les pixels de la sous-matrice S à l'échelle du schéma électrique de la sous matrice S mais aussi à l'échelle des diagrammes de potentiels dans le substrat semi-conducteur des différents composants de la sous-matrice de pixels S. Cette approche permet une meilleure compréhension des phénomènes physiques qui régissent le fonctionnement avec sommation dans la structure décrite selon l'invention.

Dans la figure 6a il est possible de distinguer les étapes suivantes :
1. L'étape PH0 : Réinitialisation de l'étage de lecture.
2. L'étape PH1 : Intégration des charges électriques par les photodiodes.
3. L'étape PH2 : Stockage des charges électriques des pixels Pxl_{i,j} et Pxl_{i+1,j} de la colonne réceptrice.
4. L'étape PH3 : Sommation horizontale des charges électriques.
5. L'étape PH4 : Sommation verticale des charges électriques et lecture.

Nous allons décrire ce processus étape par étape.

A t0, le front montant sur le signal de contrôle externe RSTᵢ déclenche l'étape de réinitialisation PH0 qui force la valeur du nœud de détection SN de chaque pixel à une tension prédéterminée. Cette étape n'intervient pas directement dans la fonctionnalité de la sommation des charges électriques des pixels mais il est clair pour l'Homme du métier que la réinitialisation est indispensable pour un fonctionnement compatible avec un double échantillonnage corrélé.

Ensuite, la phase d'intégration des charges PH1 est déclenchée et l'ensemble des signaux de contrôle sont mis à un potentiel bas (correspondant à un niveau logique 0) pendant une durée suffisante pour accumuler les charges électriques dans les photodiodes suite à une exposition à une lumière incidente.

La figure 6b illustre la génération des paquets de charges électriques (ellipses en pointillé CH_{i,j}, CH_{i,j+1}, CH_{i+1,j}, CH_{i+1,j+1}) par les différents éléments à effet photoélectriques qui appartiennent aux pixels constituant la sous-matrice S.

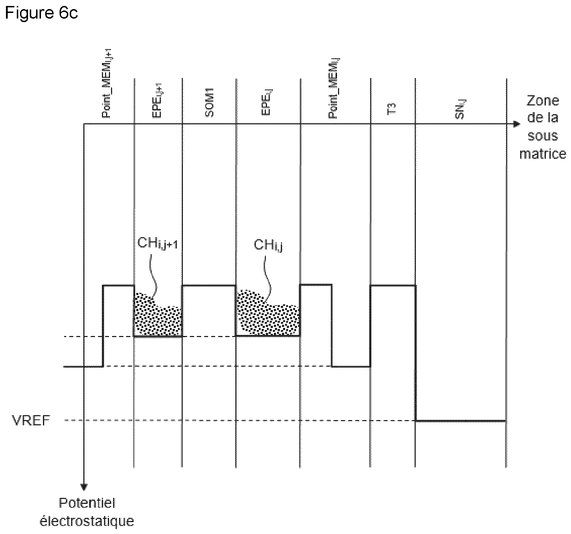

La figure 6c représente l'état du diagramme de potentiel électrostatique pendant l'étape d'intégration PH1 dans le volume du substrat semi-conducteur des différents composants de la sous-matrices S tel que présenté par la figure 6b. L'application d'un potentiel bas (avec MEM1=0 et MEM2=0) sur les tranchées CDTI qui constituent les points mémoires POINT_MEM_{i,j} et POINT_MEM_{i,j+1} induit l'établissement d'une barrière de potentiel à l'entrée des points mémoires. L'application d'un potentiel bas (avec BIN=0) sur les tranchées CDTI qui constituent l'étage de sommation SOM1 établit aussi une barrière de potentiel rendant l'étage de sommation bloquant pour la propagation des charges. Il est obtenu ainsi un puits de potentiel au niveau du volume des éléments à effet photoélectrique EPE_{i,j} et EPE_{i,j+1} tel que représenté dans la figure 6c. On observe bien que les charges générées CH_{i,j} et CH_{i,j+1} sont piégées dans les puits de potentiels au niveau des photodiodes. Par symétrie, pendant l'étape d'intégration, le même diagramme de potentiel électrostatique est obtenu pour les deux pixels Pxl_{i+1,j} et Pxl_{i+1,j+1}

Après un certain délai, la phase d'intégration PH1 s'achève et le front montant sur le signal MEM1 déclenche l'étape de stockage des charges électriques des pixels Pxl_{i,j} et Pxl_{i+1,j} de la colonne réceptrice Cⱼ, notée PH2. Simultanément, le signal de contrôle MEM2 est maintenu à un niveau logique bas, maintenant ainsi la barrière de potentiel entre les photodiodes des pixels Pxl_{i,j+1} et Pxl_{i+1,j+1} de la colonne réceptrice Cⱼ et les entrées des points mémoires appartenant aux mêmes pixels.

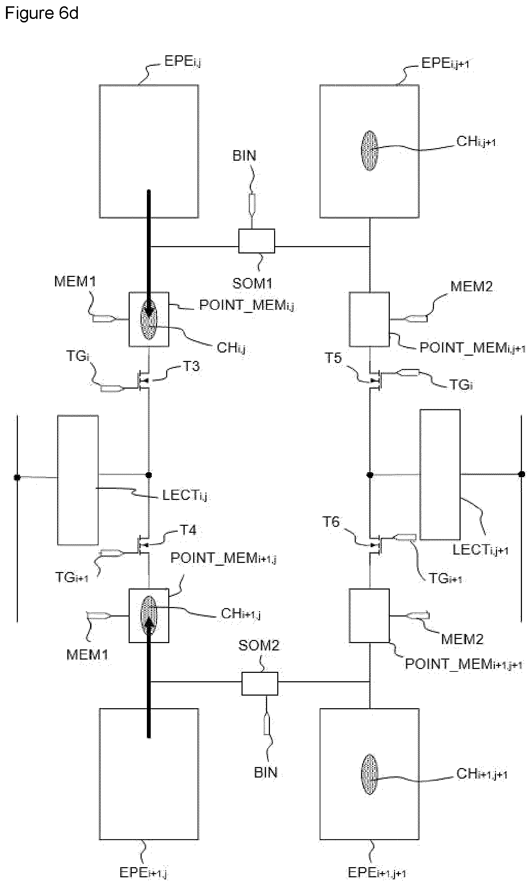

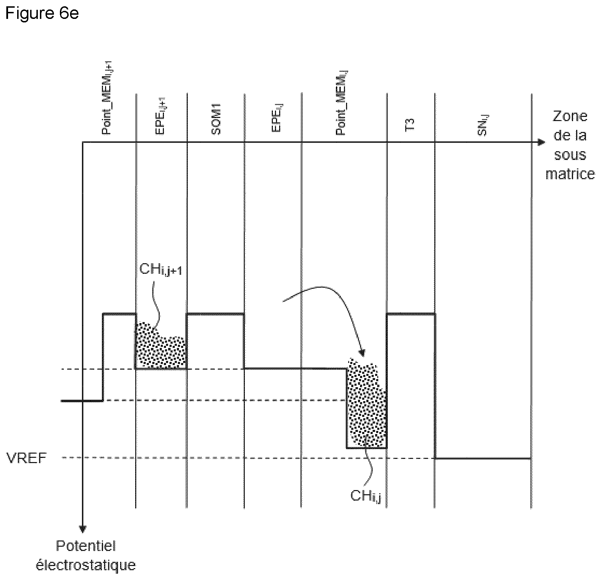

Les figures 6d et 6e montrent la déplacement des charges électriques des pixels Pxl_{i,j} et Pxl_{i+1,j} de la colonne réceptrice Cⱼ vers les points mémoire POINT_MEM_{i,j} et POINT_MEM_{i,j} suite au front montant du signal MEM1. Le diagramme de potentiel électrostatique de la figure 6e montre ce déplacement des charges vers les points mémoires dans les pixels de la colonne Cⱼ avec MEM1=1 (état logique haut) (abaissant les barrières de potentiel entre les points mémoire et les photodiodes de Cⱼ) et le confinement des charges électriques dans les photodiodes des pixels de la colonne Cⱼ₊₁ avec MEM2=0 (état logique bas)(maintenant les barrières de potentiel entre les points mémoire et les photodiodes de Cⱼ₊₁).

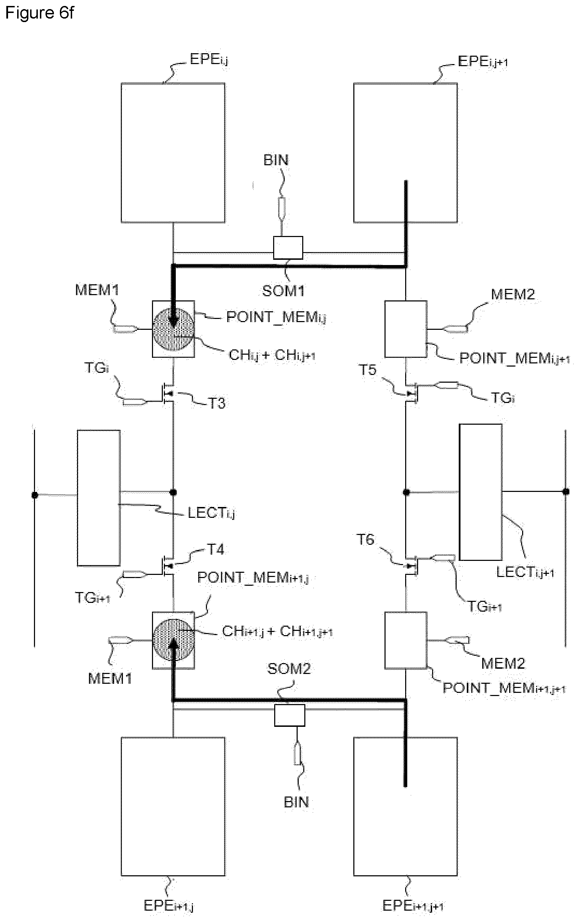

L'activation du signal de contrôle BIN qui commande les étages de sommation SOM1 et SOM2, et le maintien de MEM2 à un niveau de potentiel bas, déclenchent l'étape PH3. Les charges électriques CH_{i,j+1} et CH_{i+1,j+1} qui étaient générées puis confinées dans les photodiodes des pixels Pxl_{i,j+1} et Pxl_{i+1,j+1}, passent respectivement à travers les étages de sommation SOM1 et SOM2. Puisque le signal de contrôle MEM1 est maintenu à un potentiel haut (les entrées de POINT_MEM_{i,j} et POINT_MEM_{i+1,j} sont passantes), les charges électriques qui passent à travers les étages de sommation provenant de la colonne de rang j+1 Cⱼ₊₁ sont stockés à leurs tour dans les points mémoires des pixels de la colonne de rang j Cⱼ comme illustré dans la figure 6f. La sommation selon la direction des lignes est réalisée au niveau des points mémoires POINT_MEM_{i,j} et POINT_MEM_{i+1,j}. Cela présente l'avantage de préserver le gain de l'étage lecture en limitant les capacités parasites au niveau de l'entrée de l'étage de lecture.

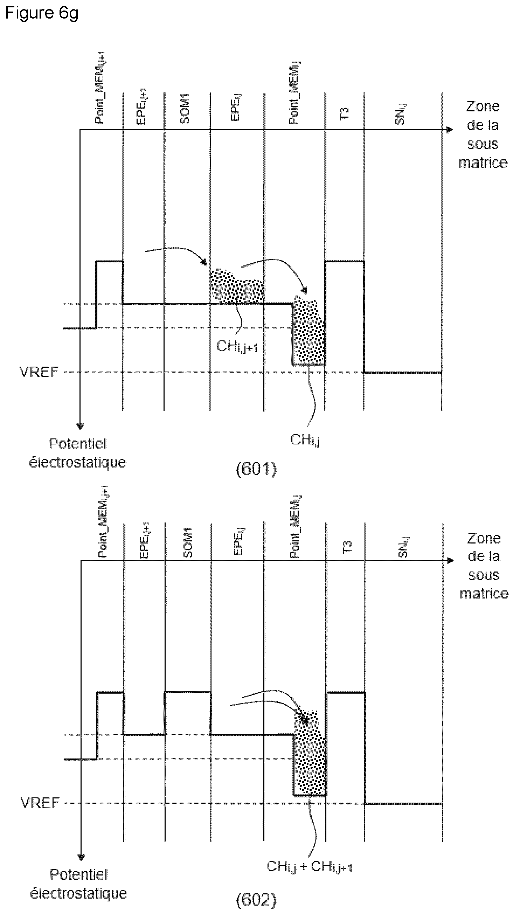

Le diagramme de potentiel électrostatique 601 de la figure 6g montre la migration des charges électriques de l'élément à effet photoélectrique EPE_{i,j+1} à travers l'étage de sommation SOM1 pour accéder dans une étape intermédiaire à l'élément à effet photoélectrique EPE_{i,j} et continuer ensuite vers le corps du POINT_MEM_{i,j} comme illustré dans le diagramme 602 de la figure 6g. Par symétrie, la même disposition de barrières de potentiel est obtenue dans le substrat de la ligne de rang i+1 permettant la migration des charges électriques de la photodiode du pixel Pxl_{i,j+1} vers le point mémoire du pixel Pxl_{i,j+1}.

Ainsi, à l'achèvement de la phase PH3, la sommation horizontale dans la sous-matrice S est effectuée pour chaque ligne. La symétrie de la structure donne à l'Homme du métier la possibilité d'effectuer une sommation horizontale dans les deux sens en adaptant la séquence de signaux de contrôle BIN, MEM1 et MEM2.

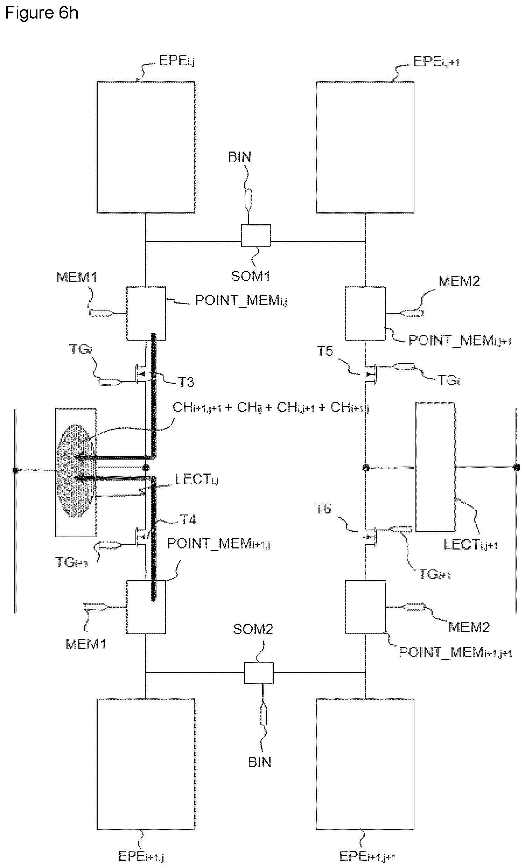

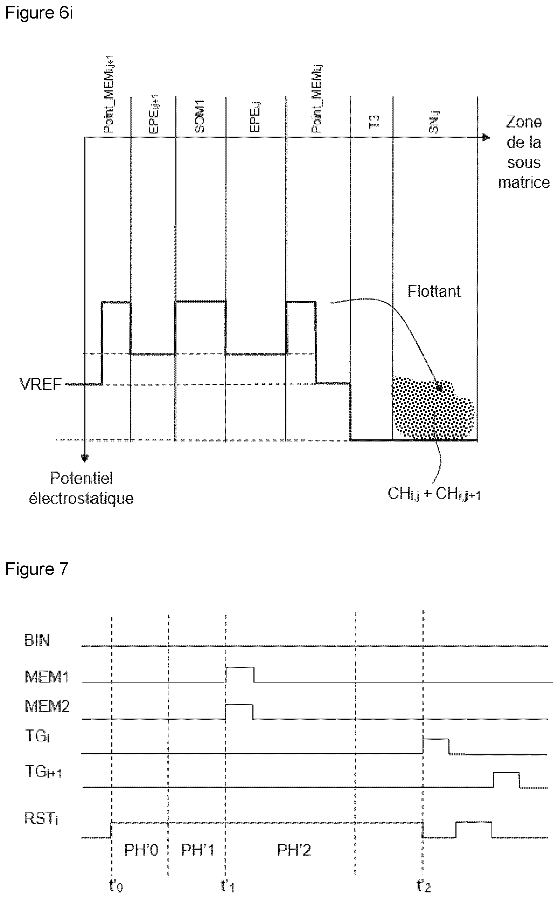

Le front descendant sur le signal de contrôle MEM1 à t4 déclenche la phase suivante PH4 de sommation horizontale et de lecture. Etant compatible avec un double échantillonnage corrélé, l'échantillonnage de la valeur de réinitialisation s'effectue juste avant le front descendant du signal de réinitialisation RSTᵢ. A t6, deux impulsions simultanées (ou consécutives selon la programmation tant que RSTᵢ est maintenu à un état logique bas) sur les deux signaux TGᵢ et TGᵢ₊₁ activent les deux grilles de transfert T3 et T4 en baissant leurs barrières de potentiel comme illustré dans les figure 6h et 6i. Ainsi les charges stockées auparavant dans les points mémoires POINT_MEM_{i,j} et POINT_MEM_{i+1,j} sont regroupées au niveau du nœud de détection SN_{i,j}. L'ensemble des charges générées par les quatre pixels de la sous-matrice S sont additionnés et accumulées dans le même nœud de détection SN_{i,j}. et converties en tension électrique, et adaptées par l'étage de lecture LECT_{i,j} et le signal utile est échantillonné pour effectuer un double échantillonnage corrélé ultérieurement au niveau système dans le capteur d'image.

Les détails du déroulement du double échantillonnage corrélé ne sont pas décrits ici pour simplifier la compréhension du processus de la sommation des charges électriques des pixels de la sous-matrice (Binning). L'homme du métier dispose de tous les éléments nécessaires pour implémenter le la sommation des charges électriques de pixels selon l'invention avec ce type d'échantillonnage.

La figure 7 représente un chronogramme de fonctionnement de la sous-matrice illustrée dans la figure 1 sans sommation des charges électriques.

Les phases de réinitialisation et d'intégration PH'0 et PH'1 sont identiques au chronogramme de la figure 6a.

A t'1, les deux impulsions sur les signaux de contrôle MEM1 et MEM2 ouvrent l'accès à tous les points mémoires appartenant aux pixels qui forment la sous-matrice S. Ainsi, les charges générées par chacune des photodiodes migrent vers les points mémoires associés effectuant ainsi la phase PH'2 de stockage des charges électriques dans un fonctionnement en obturation globale. Le signal BIN est maintenu à un état logique bas pour conserver la barrière de potentiel entre deux éléments photoélectriques adjacents appartenant à la même ligne.

A partir de t'2, les deux impulsions consécutives sur les signaux de contrôle TGᵢ et TGᵢ₊₁ permettent d'activer successivement les grilles de transfert T3, T4, T5 et T6 et ainsi d'accumuler les charges du pixels Pxl_{i,j} sur le nœud de détection SN_{i,j} et de Pxl_{i,j+1} sur le nœud de détection SN_{i,j+1}(pour être propagées respectivement aux étages de lecture LECT_{i,j}et LECT_{i,j+1}) puis dans un second temps d'accumuler les charges du pixels Pxl_{i+1,j} sur le nœud de détection SN_{i,j} et de PxI_{i+1,j+1} sur le nœud de détection SN_{i,j+1} (pour être propagées respectivement aux étages de lecture LECT_{i,j} et LECT_{i,j+1}).

On obtient ainsi un fonctionnement sans sommation au sein des pixels qui forment la sous-matrice S en obturation globale.

Un avantage de l'invention est que l'implémentation proposée permet à un fonctionnement avec ou sans sommation de charges.

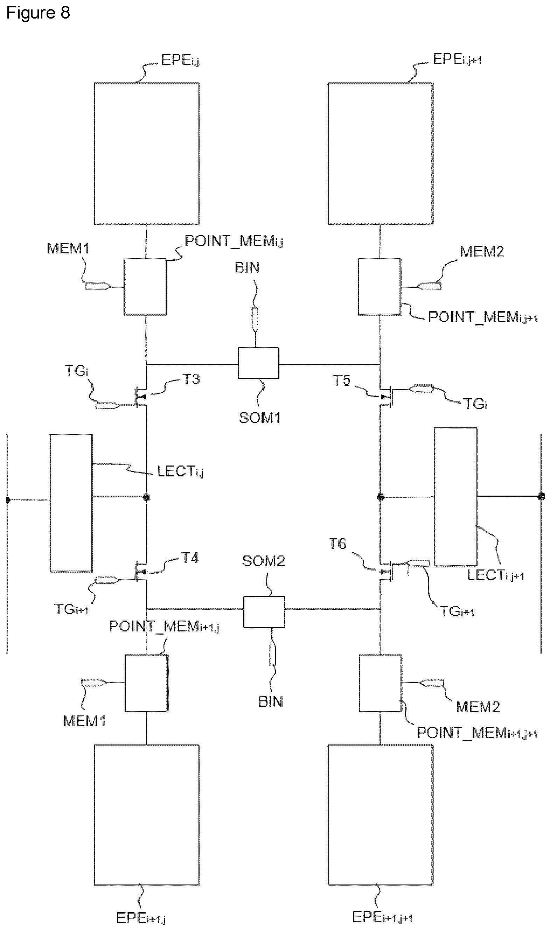

La figure 8 représente un schéma fonctionnel d'une sous-matrice de pixels selon un deuxième mode de réalisation de l'invention.

Le deuxième mode de réalisation de la sous-matrice S se distingue du premier mode de réalisation par la connexion de l'étage de sommation SOM1 entre les sorties des points mémoires POINT_MEM_{i,j} et POINT_MEM_{i,j+1} appartenant à la ligne de rang i Lᵢ de la sous-matrice S et la connexion de l'étage de sommation SOM2 entre les sorties des points mémoires POINT_MEM_{i+1,j} et POINT_MEM_{i+1,j+1} appartenant à la ligne de rang i+1 Lᵢ₊₁ de la sous-matrice S.

Le deuxième mode de réalisation décrit dans la figure 8 présente l'avantage technique de la possibilité d'intervertir les lignes et les colonnes lors de son l'implémentation. Il permet aussi d'augmenté la quantité de charges stockables dans les points mémoires POINT_MEM_{i,j} et POINT_MEM_{i,j+1} appartenant à la même ligne puisqu'ils seront isolés entre elles par l'étage de sommation SOM1. (de même pour les points mémoires POINT_MEM_{i,j} et POINT_MEM_{i,j+1} ).

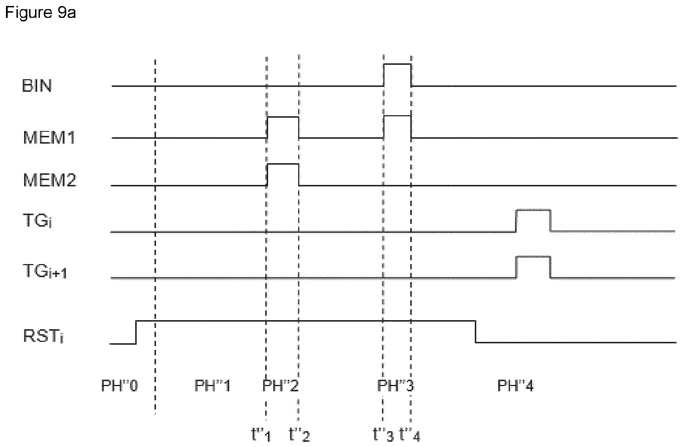

La figure 9a représente un chronogramme de fonctionnement de la sous-matrice illustrée à la figure 8 avec sommation des charges électriques selon le deuxième mode de réalisation de l'invention.

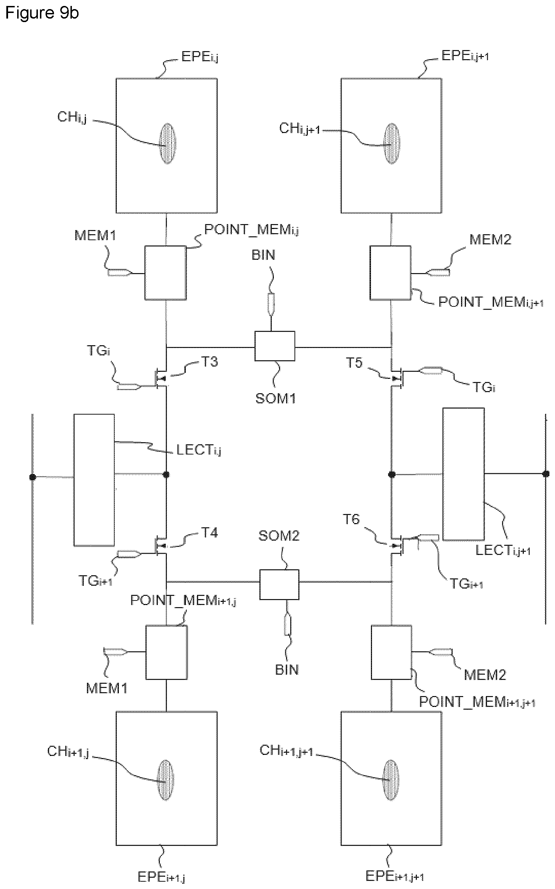

Les figures 9b à 9e illustrent le cheminement des charges électriques pendant les différentes étapes de sommation dans la sous-matrice S selon le deuxième mode de réalisation.

Les phases de réinitialisation et d'intégration PH"0 et PH"1 sont identiques à celles du chronogramme de la figure 6a (à savoir PH0 et PH1).

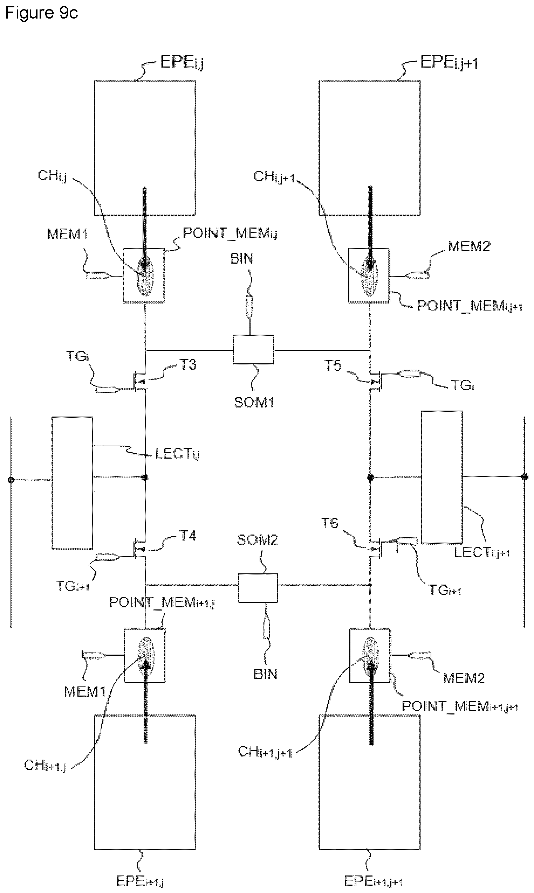

Suite à l'intégration des charges par les photodiodes des pixels de la sous-matrice S, comme illustré à la figure 9b, et à l'instant t"1, les deux impulsions sur les signaux MEM1 et MEM2 ouvrent les barrières de potentiel aux entrées des points mémoires de tous les pixels de la sous-matrice S. Ainsi les charges sont stockées dans les différents points mémoires tel que représenté sur la figure 9c et l'étape PH"2 est accomplie avec les fronts descendants sur les signaux MEM1 et MEM2 à t"2.

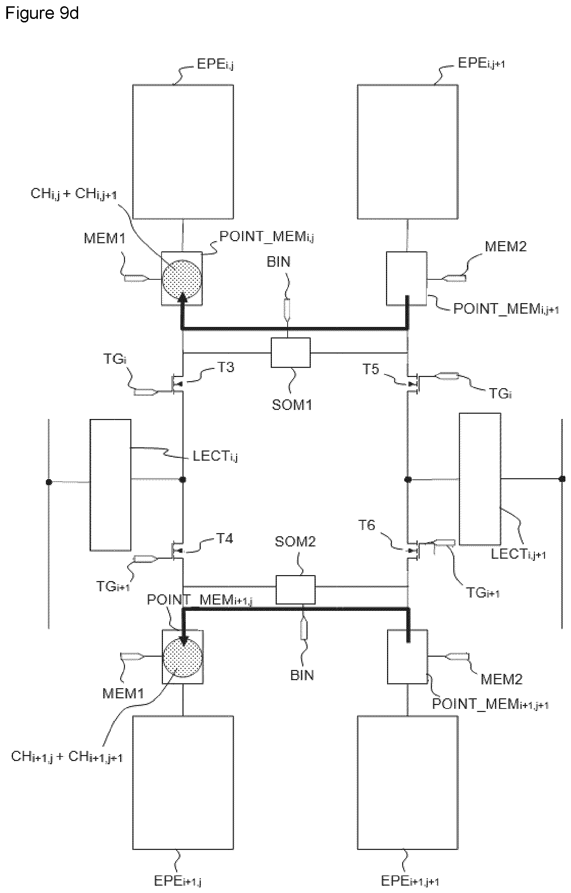

A t"3, la phase PH"3 de sommation horizontale est déclenchée avec les deux impulsions simultanées sur les signaux BIN et MEM1 permettant aux charges stockées dans les points mémoires POINT_MEM_{i,j+1} et POINT_MEM_{i+1,j+1} de migrer respectivement vers les points mémoires POINT_MEM_{i,j} et POINT_MEM_{i+1,j} en se basant sur le même mécanisme physique décrit précédemment. Ainsi, la sommation horizontale est effectuée après la phase PH"3 comme représenté sur la figure 9d.

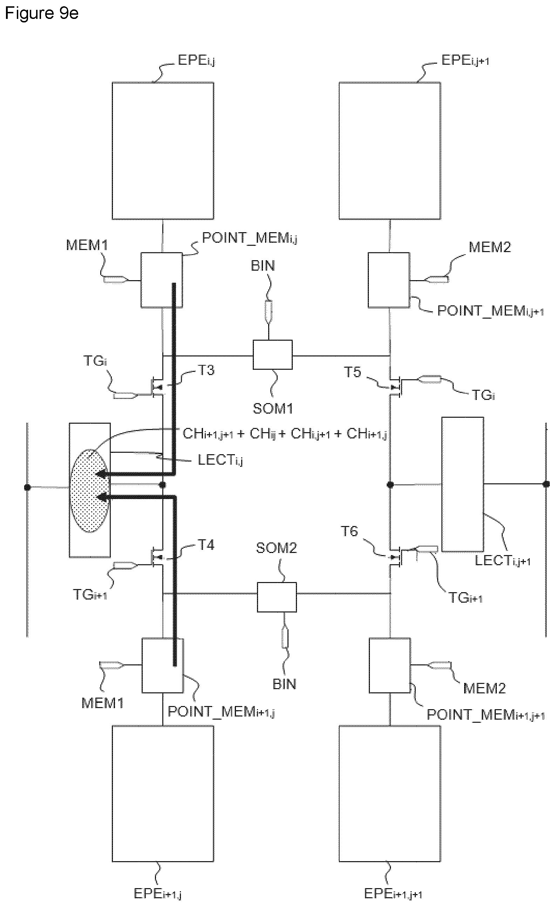

A t"4, la dernière phase de lecture et de sommation verticale PH"4 est identique à la phase PH4 décrite dans le fonctionnement de la sommation pour le premier mode de réalisation. Le résultat de cette phase est illustré à la figure 9e.

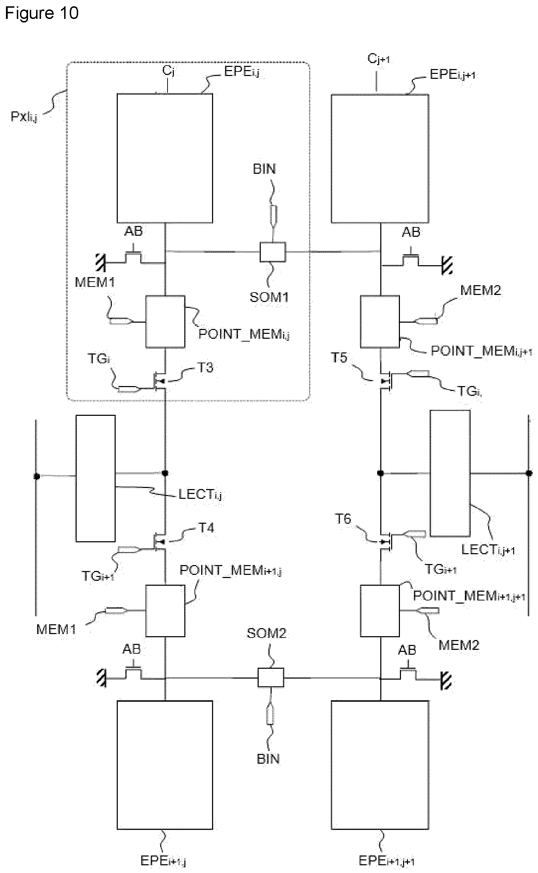

La figure 10 représente un troisième mode de réalisation d'une sous-matrice de pixels selon l'invention. Chacun des pixels intègre en plus un transistor anti-éblouissement T7 contrôlé par un signal d'entrée AB et connecté à l'élément à effet photoélectrique appartenant au même pixel. Le signal de contrôle AB est commun à tous les transistors anti-éblouissement des pixels de la sous-matrice S. Ce transistor permet de réinitialiser la photodiode à zéro sans passer par les nœuds de détection SN_{i,j} et SN_{i,j+1}. Il permet aussi le déclenchement de l'intégration de l'image suivante avant la fin de la lecture de l'image courante. On parle ici « d'intégration pendant la lecture » (Integration While Read en Anglais - IWR).

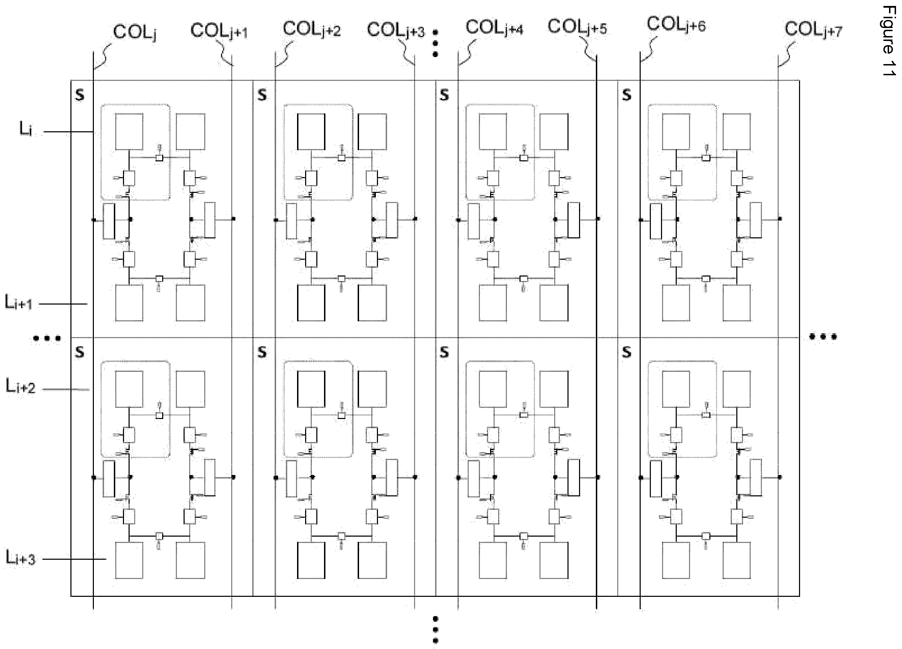

La figure 11 illustre un exemple d'implémentation des sous-matrices S selon le premier mode de réalisation de l'invention pour obtenir une matrice de pixels MP capable de réaliser une sommation de 2*2 pixels pour avoir des macro-pixels virtuels de la même taille, et de facteur de forme carré. L'abutement des sous-matrices S appartenant à une même colonne permet de connecter les lignes conductrices (CoL_{i,j}, COL_{i,j+1} ..) récupérant les signaux aux sorties des étages de lecture (LECT_{i,j}, LECT_{i+1,j}..) pour tout j de 1 à M pour former une ligne conductrice principale COLⱼ. En répétant l'opération d'abutement sur les deux dimensions spatiales la matrice de pixels MP est obtenue.

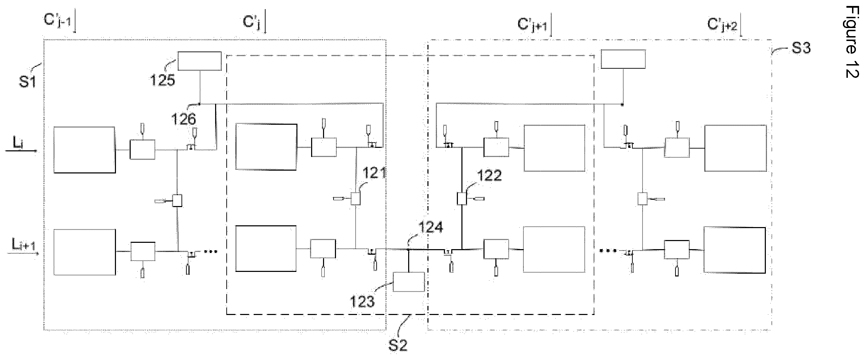

La figure 12 représente un exemple d'implémentation d'une matrice de pixels contenant des sous-matrices de pixels selon une variante du deuxième mode de réalisation de l'invention illustré à la figure 8.

Les sous-matrices ne sont pas abutées l'une à l'autre mais elles partagent entre elles des parties communes tel qu'on peut l'observer dans les sous-matrices S1 et S2 de la figure 12. La sous-matrice S1 est composée des pixels de la colonne C'ⱼ et C'ⱼ La sous-matrice S2 est composée des pixels de la colonne C'ⱼ et C'ⱼ₊₁. La sous-matrice S3 est composée des pixels de la colonne C'ⱼ₊₁ et C'ⱼ₊₂.

Si on prend l'exemple de la sous-matrice S2, les étages de sommation 121 et 122 connectent les pixels appartenant à une même colonne et non une même ligne tel que cela a été décrit à la figure 8. De plus, la sous-matrice S2 comprend un seul étage de lecture 123 connecté au nœud de détection commun 124 des deux pixels appartenant à la ligne de rang i+1 Lᵢ₊₁ de la sous-matrice S2. D'un autre côté, la sous-matrice adjacente S1 comprend un seul étage de lecture 125 connecté au nœud de détection 126 commun aux deux pixels de la ligne de rang i Lᵢ₊₁ appartenant à la sous-matrice S1. La même disposition est obtenue pour la sous-matrice S3 créant une structure symétrique alternée entre les sous-matrices adjacentes S1, S2 et S3.

Il est à souligner que ce mode de réalisation ne permet pas une sommation dans les deux sens entre les lignes au sein d'une même sous-matrice de pixels mais elle représente l'avantage d'obtenir une implémentation plus compacte par rapport aux autres modes de réalisation.

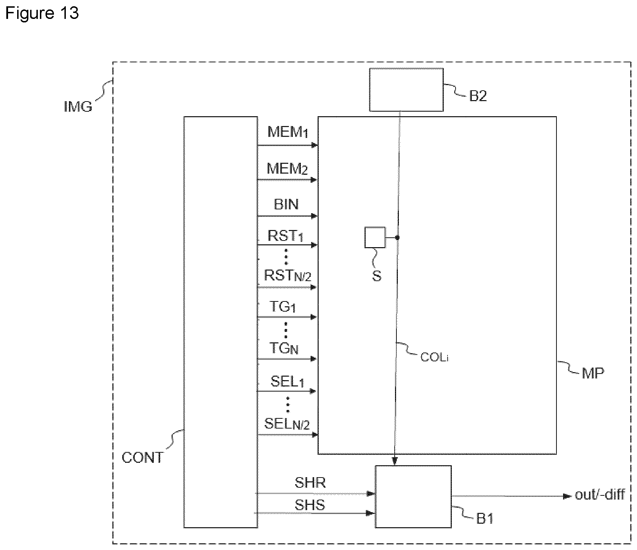

La figure 13 représente un schéma fonctionnel d'un capteur d'images IMG intégrant une matrice de pixels selon l'un des modes de réalisation de l'invention. Le capteur d'images à pixels actifs décrit à la figure 13 comporte les éléments suivants.

Une matrice de pixels actifs MP contient au moins une sous-matrice S réalisée selon l'invention. La matrice est constituée de lignes et de colonnes de pixels. Sur la figure 13, une seule sous-matrice S a été représentée dans la matrice pour simplifier la représentation.

Le capteur d'images IMG comporte aussi un circuit CONT de génération des signaux de commande des pixels. Ce circuit sert à contrôler les différentes phases de fonctionnement des pixels actifs de la matrice MP en générant, pour chaque pixel, les signaux SELᵢ avec i de 1 à N/2 pour la phase de lecture, TGᵢ avec i de 1 à N pour la phase de transfert de charge et RSTᵢ, avec i de 1 à N/2 pour la réinitialisation des nœuds de détection. Le circuit de contrôle CONT génère aussi les signaux MEM1, MEM2 et BIN qui gèrent les phases de sommation horizontale et verticale. De plus, ce bloc génère deux autres signaux de contrôle, à savoir, SHR et SHS qui commandent la phase d'échantillonnage.

Le capteur d'images comporte encore un circuit d'échantillonnage B1 agencé au pied de chaque colonne de la matrice de pixels et connecté à la sortie de l'étage de lecture de chaque pixel de la colonne correspondante. Un circuit de double échantillonnage corrélé B1 peut être utilisé pour implémenter cette fonction. Cette solution de double échantillonnage corrélé permet de lire les signaux tout en éliminant le bruit kTC généré dans les pixels de la colonne concernée. Dans un premier temps, le signal de sortie du pixel échantillonné suite à une réinitialisation est enregistré. L'échantillon enregistré correspond au signal de réinitialisation. Dans un deuxième temps, le signal échantillonné après une exposition du pixel à la lumière est enregistré. L'échantillon enregistré correspond au signal utile. Une soustraction entre les deux signaux échantillonnés permet d'éliminer le bruit kTC. Le résultat de cette mesure différentielle out_diff est transmis vers un convertisseur analogiquenumérique non représenté sur la figure 13 par souci de simplification. Il convient de noter que la lecture des échantillons se fait toujours ligne par ligne dans le cas d'une obturation globale ou déroulante.

Le capteur d'images comporte encore un circuit d'alimentation B2 pour alimenter chaque colonne de la matrice de pixels. Dans la figure 13, il s'agit d'une source de courant reliée au conducteur de la colonne. Cette source de courant commune à tous les pixels d'une colonne sert à polariser les transistors de l'étage d'amplification lors d'une lecture du pixel.

D'autres variantes du capteur d'images incluant une matrice de pixels actifs selon l'invention peuvent être conçues aisément par l'Homme du métier.

L'invention décrite permet d'implémenter un capteur d'images CMOS dont le réseau matriciel est réalisé via des sous-matrices 2*2 permettant l'implémentation de la fonctionnalité de sommation de pixels (Pixels Binning) dans le domaine des charges. Cette caractéristique permet d'améliorer la sensibilité du capteur d'image dans des conditions de faible luminosité mais aussi de réduire le bruit de chaine dans la matrice de pixels. Cela permet alors d'augmenter le rapport signal à bruit du capteur d'images.

Ainsi, la solution décrite par l'invention se démarque de l'état de l'art au moins par la réalisation de sommation de pixels dans le domaine des charges tout en restant compatible avec un fonctionnement en obturation globale. De plus, l'invention présente l'avantage de réduire la capacité du nœud de détection par rapport à la technique de partage de quatre nœuds de sortie mis en commun utilisée par les implémentations de l'état de l'art. Le capteur d'images selon l'invention laisse toujours la possibilité de fonctionner sans sommation de charges électriques ce qui donne à l'Homme de métier une flexibilité d'adapter le fonctionnement des capteurs selon les conditions de l'environnement de la prise d'images en modifiant la séquence de signaux de contrôle qui régissent l'activation de la sommation analogique de pixels.

## Revendications

1. Une matrice de pixels (MP) de N lignes (Lᵢ) et M colonnes (Cⱼ) réalisée dans un substrat semi-conducteur, la matrice comprenant au moins une sous-matrice (S) de quatre pixels adjacents (Pxlᵢⱼ , Pxl_{(i+1),j} , Pxl_{i,(j+1)} , Pxl _{(i+1),(j+1)}),
chacun des pixels de la sous-matrice (S) comportant :
- un ensemble d'un élément à effet photoélectrique (EPE_{i,j}, EPE_{i+1,j}, EPE_{i,j+1}, EPE_{i+1,j+1}) pour générer des charges électriques en réponse à une radiation électromagnétique incidente et d'un point mémoire (POINT_MEM_{i,j}, POINT_MEM_{i,j+1}, POINT_MEM_{i+1,j}, POINT_MEM_{i+1,j+1}) connecté à la sortie de l'élément à effet photoélectrique (EPEi,j, EPEi+1,j, EPEi,j+1, EPEi+1,j+1) pour stocker les charges électriques générées,
- un nœud de détection (SNᵢⱼ, SN_{i,j+1}),
- une grille de transfert (T3, T5, T6, T4), connectée entre la sortie du point mémoire (POINT_MEM_{i,j}, POINT_MEM_{i,j+1}, POINT_MEM_{i+1,j}, POINT_MEM_{i+1,j+1}) et le nœud de détection (SN ᵢⱼ, SN _{i,j+1}),
- un étage de sommation (SOM1, SOM2),
l'étage de sommation étant connecté au dit ensemble et étant commun avec un pixel (Pxl_{i,j+1} ) adjacent de la sous-matrice (S) appartenant à la même ligne (Lᵢ) dudit pixel (Pxlᵢⱼ ),
au moins un nœud de détection (SNᵢⱼ, SN_{i,j+1}) par sous-matrice (S) étant commun à deux pixels adjacents (Pxlᵢⱼ , Pxl_{(i+1),j}) de la sous-matrice (S) appartenants à la même colonne (Cⱼ),
la matrice de pixels comprenant en outre au moins un étage de lecture (LECTᵢⱼ, LECT_{i,j+1}) par sous-matrice (S), connecté au nœud de détection commun (SNᵢⱼ, SN_{i,j+1}) ;
la matrice de pixels étant **caractérisée en ce que**
chacun des points mémoires (POINT_MEM_{i,j}) étant réalisé par un agencement de deux couples de tranchées d'isolation profondes (dti3, dti4, dti5, dti6), les tranchées d'isolation profondes formant deux confinements des charges électriques, le premier confinement constituant l'entrée du point mémoire étant formé par le premier couple de tranchées (dti3, dti4) disposées parallèlement et séparées par une première distance (d2), et le second confinement constituant le corps du point mémoire étant formé par le second couple de tranchées (dti5, dti6) disposées parallèlement et séparées par une seconde distance (d3); la première distance étant inférieure à la seconde distance.

2. Une matrice de pixels (MP) selon la revendication 1, dans laquelle chacun des éléments à effet photoélectrique (EPE_{i,j}, EPE_{i+1,j}, EPE_{i,j+1}, EPE_{i+1,j+1}) est une photodiode pincée.

3. Une matrice de pixels (MP) selon l'une quelconque des revendications précédentes, dans laquelle chacun des étages de sommation (SOM1, SOM2) est réalisé par un couple de tranchées d'isolation profondes (dti1, dti2) agencées en parallèles.

4. Une matrice de pixels (MP) selon l'une quelconque des revendications 1 à 3, dans laquelle :
l'étage de sommation (SOM1, SOM2) est connecté entre la sortie de l'élément à effet photoélectrique (EPE_{i,j}) et la sortie de l'élément à effet photoélectrique du pixel adjacent de la sous-matrice (S) appartenant à la même ligne,
les pixels (Pxlᵢⱼ , Pxl_{(i+1),j} , Pxl_{i,(j+1)} , Pxl _{(i+1),(j+1)}) de la sous-matrice (S) appartenant à la même colonne ont un nœud de détection (SNᵢⱼ, SN_{i,j+1}) et un étage de lecture (LECTᵢⱼ, LECT_{i,j+1}) communs.

5. Une matrice de pixels (MP) selon la revendication 4, comprenant des moyens de contrôle (CONT) configurés pour appliquer (PH2) pour chaque pixel d'une même colonne (Cⱼ) :
- un potentiel haut sur les tranchées d'isolation profondes formant le point mémoire (POINT_MEM_{i,j},POINT_MEM_{i+1,j}) pour recevoir les charges électriques générées par l'élément à effet photoélectrique (EPE_{i,j}) ;
- un potentiel bas sur les tranchées d'isolation profondes formant le point mémoire (POINT_MEM_{i,j+1}, POINT_MEM_{i+1,j+1}) appartenant au pixel adjacent (Pxl_{i,j+1}) de la sous-matrice (S) appartenant à la même ligne ;
- un potentiel bas sur les tranchées d'isolation profondes formant l'étage de sommation (SOM1).

6. Une matrice de pixels (MP) selon la revendication 5, dans laquelle les moyens de contrôle (CONT) sont configurés pour appliquer simultanément (PH3) pour chaque pixel d'une même colonne (Cⱼ) :
- un potentiel haut sur les tranchées d'isolation profondes formant le point mémoire (POINT_MEM_{i,j}, POINT_MEM_{i+1,j}) ;
- un potentiel bas sur les tranchées d'isolation profondes formant le point mémoire (POINT_MEM_{i,j+1}, POINT_MEM_{i+1,j+1}) appartenant au pixel adjacent (Pxl_{i,j+1}) de la sous-matrice (S) appartenant à la même ligne (Lᵢ) ;
- un potentiel haut sur les tranchées d'isolation profondes formant l'étage de sommation (SOM1, SOM2),
pour réaliser une sommation des charges électriques générées par les pixels (Pxl_{i,j+1}, Pxl_{i,j+1}) appartenant à une même ligne (Lᵢ, Lᵢ₊₁) de la sous-matrice (S).

7. Une matrice de pixels (MP) selon l'une quelconque des revendications 1 à 3,
dans laquelle :
l'étage de sommation (SOM1, SOM2) d'un pixel de la sous-matrice (S) est connecté entre la sortie du point mémoire (POINT_MEM_{i,j}, POINT_MEM_{i,j+1}, POINT_MEM_{i+1,j}, POINT_MEM_{i+1,j+1}) et la sortie du point mémoire du pixel de la sous-matrice (S) appartenant à la même ligne ;
les pixels (Pxlᵢⱼ , Pxl_{(i+1),j} , Pxl_{i,(j+1)} , Pxl _{(i+1),(j+1)}) de la sous-matrice (S) appartenant à la même colonne ont un nœud de détection (SNᵢⱼ) et un étage de lecture (LECTᵢⱼ) communs.

8. Une matrice de pixels (MP) selon l'une quelconque des revendications 1 à 3, dans laquelle :
l'étage de sommation (SOM1, SOM2) d'un pixel de la sous-matrice (S2) est connecté entre la sortie du point mémoire (POINT_MEM_{i,j}, POINT_MEM_{i,j+1}, POINT_MEM_{i+1,j}, POINT_MEM_{i+1,j+1}) et la sortie du point mémoire du pixel de la sous-matrice (S2) appartenant à la même colonne, un premier couple de pixels (Pxl_{i+1,j}, Pxl _{i+1,j+1}) de la sous-matrice (S2) appartenant à la même ligne partagent un nœud de détection (SNᵢⱼ) et un étage de lecture (LECTᵢⱼ) communs,
un second couple de pixels (Pxlᵢⱼ , Pxl_{i+1,j} ) d'une sous -matrice (S2) appartenant à la même colonne sont partagés avec une sous-matrice adjacente (S1),
le premier couple de pixels (Pxli,j , Pxl i+1,j+1 ) de la sous matrice adjacente (S1) étant disposé sur une ligne différente du premier couple de pixels de la sous-matrice (S2).

9. Une matrice de pixels (MP) selon l'une des revendications 7 ou 8, dans laquelle les moyens de contrôle (CONT) sont configurés pour appliquer (PH"2) pour chaque pixel de la sous-matrice (S) :
- un potentiel haut sur les tranchées d'isolation profondes formant le point mémoire (POINT_MEM_{i,j}, POINT_MEM_{i+1,j} POINT_MEM_{i,j+1}, POINT_MEM_{i+1,j+1}) pour recevoir les charges électriques générées par les éléments à effet photoélectrique (EPE_{i,j}, EPE_{i+1,j}, EPE_{i,j+1}, EPE_{i+1,j+1}) ;
- un potentiel bas sur les tranchées d'isolation profondes formant les étages de sommation (SOM1, SOM2).

10. Une matrice de pixels (MP) selon la revendication 9, dans laquelle les moyens de contrôle (CONT) sont configurés pour appliquer simultanément (PH"3) sur un couple de pixels adjacents selon une première direction :
- un potentiel haut sur les tranchées d'isolation profondes formant le point mémoire (POINT_MEM_{i,j}, POINT_MEM_{i+1,j}) ;
- un potentiel bas sur les tranchées d'isolation profondes formant le point mémoire (POINT_MEM_{i,j+1}, POINT_MEM_{i+1,j+1}) appartenant au pixel adjacent (Pxl_{i,j+1}) de la sous-matrice (S) selon une seconde direction différente de la première direction ;
- un potentiel haut sur les tranchées d'isolation profondes formant les étages de sommation (SOM1, SOM2) ;
pour réaliser une sommation des charges électriques générées par les pixels adjacents selon la seconde direction.

11. Une matrice de pixels (MP) selon l'une des revendications 6 ou 10, dans laquelle les moyens de contrôle (CONT) sont configurés pour appliquer, sur le couple de pixels adjacents selon une première direction, par exemple sur deux pixels de la même colonne (Cⱼ),
un potentiel haut sur les grilles de transfert (T3, T4) pour réaliser une sommation des charges électriques générées dans l'étage de lecture (LECT_{i,j}) commun.

12. Une matrice de pixels (MP) selon l'une quelconque des revendications précédentes, dans laquelle chaque étage de lecture (LECTᵢⱼ, LECT_{i,j+1}) comprend :
- un transistor de réinitialisation (T7) connecté au nœud de détection pour réinitialiser le nœud de détection (SNᵢⱼ) à une tension d'alimentation choisie (VREF) ;
- un transistor d'amplification (T8) monté en drain commun dont la grille est connectée au nœud de détection (SNᵢⱼ) ;
- un transistor de sélection (T9) connecté à la sortie du transistor amplificateur (T8) pour échantillonner le signal de sortie.

13. Capteur d'images (IMG) comprenant :
- une matrice de pixels (MP) selon l'une quelconque des revendications précédentes,
- un circuit de génération des signaux de commande des pixels (CONT),
- un circuit d'échantillonnage (B1) agencé au pied de chaque colonne de la matrice de pixels connecté à la sortie de l'étage de lecture de chaque pixel de la colonne correspondante,
- un circuit d'alimentation (B2) pour alimenter chaque colonne de la matrice de pixels.

14. Capteur d'images (IMG) selon la revendication 13 dans lequel le circuit d'échantillonnage (B1) est un circuit de double échantillonnage corrélé.

15. Capteur d'images (IMG) selon l'une des revendications 13 ou 14, le capteur étant adapté à un fonctionnement en obturation globale.

## Patentansprüche

1. Pixelmatrix (MP) mit N Zeilen (Lᵢ) und M Spalten (Cⱼ), die in einem Halbleitersubstrat hergestellt ist, wobei die Matrix mindestens eine Untermatrix (S) mit vier benachbarten Pixeln (Pxlᵢⱼ, Pxl_{(i+1),j}, Pxl_{i,(j+1)}, Pxl_{(i+1),(j+1)}) umfasst,
wobei jedes der Pixel der Untermatrix (S) Folgendes aufweist:
- einen Satz aus einem Fotoeffektelement (EPE_{i,j}, EPE_{i+1,j}, EPE_{i,j+1}, EPE_{i+1,j+1}) zum Erzeugen von elektrischen Ladungen als Reaktion auf eine einfallende elektromagnetische Strahlung und einem Speicherpunkt (POINT_MEM_{i,j}, POINT_MEM_{i,j+1}, POINT_MEM_{j+1,j}, POINT_MEM_{i+1,j+1}), der an den Ausgang des Fotoeffektelements (EPE_{i,j}, EPE_{i,1,j}, EPE_{i,j+1}, EPE_{i+1,j+1}) angeschlossen ist, um die erzeugten elektrischen Ladungen zu speichern,
- einen Detektionsknoten (SNᵢⱼ, SN_{i,j+1}),
- ein Übertragungsgatter (T3, T5, T6, T4), das zwischen dem Ausgang des Speicherpunktes (POINT_MEM_{i,j}, POINT_MEM_{i,j+1}, POINT_MEM_{j+1,j}, POINT_MEM_{j+1,j+1}) und dem Detektionsknoten (SNᵢⱼ, SN_{i,j+1}) angeschlossen ist,
- eine Binningstufe (SOM1, SOM2),
wobei die Binningstufe mit dem Satz verbunden ist und einem benachbarten Pixel (Pxl_{i,j+1}) der Untermatrix (S) gemeinsam ist, das zur selben Zeile (Lᵢ) des Pixels (Pxlᵢⱼ) gehört,
wobei mindestens ein Detektionsknoten (SNᵢⱼ, SN_{i,j+1}) pro Untermatrix (S) zwei benachbarten Pixeln (Pxlᵢⱼ, Pxl_{(i+1),j}) der Untermatrix (S), die zur selben Spalte (Cⱼ) gehören, gemeinsam ist,
wobei die Pixelmatrix ferner mindestens eine Lesestufe (LECTᵢⱼ, LECT_{i,j+1}) pro Untermatrix (S) umfasst, die an den gemeinsamen Detektionsknoten (SNᵢⱼ, SN_{i,j+1}) angeschlossen ist;
wobei die Pixelmatrix **dadurch gekennzeichnet ist, dass** jeder der Speicherpunkte (POINT_MEM_{i,j}) durch eine Anordnung von zwei Paaren von tiefen Isolationsgräben (dti3, dti4, dti5, dti6) hergestellt ist, wobei die tiefen Isolationsgräben zwei Confinements der elektrischen Ladungen bilden, wobei das erste Confinement, das den Eingang des Speicherpunktes bildet, durch das erste Paar von Gräben (dti3, dti4) gebildet ist, die parallel angeordnet und durch einen ersten Abstand (d2) getrennt sind, und das zweite Confinement, das den Körper des Speicherpunktes bildet, durch das zweite Paar von Gräben (dti5, dti6) gebildet ist, die parallel angeordnet und durch einen zweiten Abstand (d3) getrennt sind;
wobei der erste Abstand kleiner als der zweite Abstand ist.

2. Pixelmatrix (MP) nach Anspruch 1, wobei jedes der Fotoeffektelemente (EPE_{i,j}, EPE_{j+1,j}, EPE_{i,j+1}, EPE_{j+1,j+1}) eine Klemmfotodiode ist.

3. Pixelmatrix (MP) nach einem der vorstehenden Ansprüche, wobei jede der Binningstufen (SOM1, SOM2) durch ein Paar von parallel angeordneten tiefen Isolationsgräben (dti1, dti2) hergestellt ist.

4. Pixelmatrix (MP) nach einem der Ansprüche 1 bis 3, wobei:
die Binnungstufe (SOM1, SOM2) zwischen dem Ausgang des Fotoeffektelements (EPE_{i,j}) und dem Ausgang des Fotoeffektelements des benachbarten Pixels der Untermatrix (S), das zur selben Zeile gehört, angeschlossen ist,
wobei die Pixel (Pxlᵢⱼ, Pxl_{(i+1),j}, Pxl_{i,(j+1)}, Pxl_{(i+1),(j+1)}) der Untermatrix (S), die zur selben Spalte gehören, einen Detektionsknoten (SNᵢⱼ, SN_{i,j+1}) und eine Lesestufe (LECTᵢⱼ, LECT_{i,j+1}) gemeinsam haben.

5. Pixelmatrix (MP) nach Anspruch 4, umfassend Steuermittel (CONT), die dafür konfiguriert sind, für jedes Pixel der selben Spalte (Cⱼ) Folgendes anzulegen (PH2):
- ein hohes Potential an die tiefen Isolationsgräben, die den Speicherpunkt (POINT_MEM_{i,j}, POINT_MEM_{i+1,j}) bilden, um die von dem Fotoeffektelement (EPE_{i,j}) erzeugten elektrischen Ladungen zu empfangen;
- ein niedriges Potential an den tiefen Isolationsgräben, die den Speicherpunkt (POINT_MEM_{i,j+1}, POINT_MEM_{i+1,j+1}) bilden, der zum benachbarten Pixel (Pxl_{i,j+1}) der Untermatrix (S) gehört, das zur selben Zeile gehört;
- ein niedriges Potential an die tiefen Isolationsgräben, die die Binnungstufe (SOM1) bilden.

6. Pixelmatrix (MP) nach Anspruch 5, wobei die Steuermittel (CONT) dafür konfiguriert sind, gleichzeitig für jedes Pixel der selben Spalte (Cⱼ) Folgendes anzulegen (PH3):
- ein hohes Potential an die tiefen Isolationsgräben, die den Speicherpunkt (POINT_MEM_{i,j}, POINT_MEM_{i+1,j}) bilden;
- ein niedriges Potential an die tiefen Isolationsgräben, die den Speicherpunkt (POINT_MEM_{i,j+1}, POINT_MEM_{i+1,j+1}) bilden, der zum benachbarten Pixel (Pxl_{i,j+1}) der Untermatrix (S) gehört, das zur selben Zeile (Lᵢ) gehört;
- ein hohes Potential an die tiefen Isolationsgräben, die die Binnungstufe (SOM1, SOM2) bilden,
um ein Binning der elektrischen Ladungen auszuführen, die von den Pixeln (Pxl_{i,j+1}, Pxl_{i,j+1}) erzeugt werden, die zu einer selben Zeile (Lᵢ, Lᵢ₊₁) der Untermatrix (S) gehören.

7. Pixelmatrix (MP) nach einem der Ansprüche 1 bis 3, wobei:
wobei die Binningstufe (SOM1, SOM2) eines Pixels der Untermatrix (S) zwischen dem Ausgang des Speicherpunktes (POINT_MEM_{i,j}, POINT_MEM_{i,j+1}, POINT_MEM_{i+1,j}, POINT_MEM_{i+1,j+1}) und dem Ausgang des Speicherpunktes des Pixels der Untermatrix (S), das zur selben Zeile gehört, angeschlossen ist;
wobei die Pixel (Pxlᵢⱼ, Pxl_{(i+1),i}, Pxl_{i,(j+1)}, Pxl_{(i+1),(j+1)}) der Untermatrix (S), die zur selben Spalte gehören, einen Detektionsknoten (SNᵢⱼ) und eine Lesestufe (LECTᵢⱼ) gemeinsam haben.

8. Pixelmatrix (MP) nach einem der Ansprüche 1 bis 3, wobei:
die Binningstufe (SOM1, SOM2) eines Pixels der Untermatrix (S2) zwischen dem Ausgang des Speicherpunktes (POINT_MEM_{i,j}, POINT_MEM_{i,j+1}, POINT_MEM_{i+1,j}, POINT_MEM_{i+1,j+1}) und dem Ausgang des Speicherpunktes des Pixels der Untermatrix (S2), das zur selben Spalte gehört, angeschlossen ist, wobei ein erstes Paar von Pixeln (Pxl_{i+1,j}, Pxl_{i+1,j+1}) der Untermatrix (S2), die zur selben Zeile gehören, einen gemeinsamen Detektionsknoten (SNᵢⱼ) und eine gemeinsame Lesestufe (LECTᵢⱼ) teilen,
wobei ein zweites Paar von Pixeln (Pxlᵢⱼ, Pxl_{i+1,j}) einer Untermatrix (S2), die zur selben Spalte gehören, mit einer benachbarten Untermatrix (S1) geteilt sind,
wobei das erste Paar von Pixeln (Pxlᵢⱼ, Pxl_{i+1,j+1}) der benachbarten Untermatrix (S1) auf einer Zeile angeordnet ist, die von derjenigen des ersten Paars von Pixeln der Untermatrix (S2) verschieden ist.

9. Pixelmatrix (MP) nach einem der Ansprüche 7 oder 8, wobei die Steuermittel (CONT) dafür konfiguriert sind, für jedes Pixel der Untermatrix (S) Folgendes anzulegen (PH"2):
- ein hohes Potential an die tiefen Isolationsgräben, die den Speicherpunkt (POINT_MEM_{i,j}, POINT_MEM_{i+1,j} POINT_MEM_{i,j+1}, POINT_MEM_{i+1,j+1}) bilden, um die von den Fotoeffektelementen (EPE_{i,j}, EPE_{i+1,j}, EPE_{i,j+1}, EPE_{i+1,j+1}) erzeugten elektrischen Ladungen zu empfangen;
- ein niedriges Potential an die tiefen Isolationsgräben, die die Binnungstufen (SOM1, SOM2) bilden.

10. Pixelmatrix (MP) nach Anspruch 9, wobei die Steuermittel (CONT) dafür konfiguriert sind, gleichzeitig Folgendes an ein Paar von entlang einer ersten Richtung benachbarten Pixeln anzulegen (PH"3):
- ein hohes Potential an die tiefen Isolationsgräben, die den Speicherpunkt (POINT_MEM_{i,j}, POINT_MEM_{i+1,j}) bilden;
- ein niedriges Potential an die tiefen Isolationsgräben, die den Speicherpunkt (POINT_MEM_{i,j+1}, POINT_MEM_{i+1,j+1}) bilden, der zum entlang einer zweiten Richtung, die von der ersten Richtung verschieden ist, benachbarten Pixel (Pxl_{i,j+1}) der Untermatrix (S) gehört;
- ein hohes Potential an die tiefen Isolationsgräben, die die Binnungstufen (SOM1, SOM2) bilden;
um ein Binning der elektrischen Ladungen auszuführen, die von den entlang der zweiten Richtung benachbarten Pixeln erzeugt werden.

11. Pixelmatrix (MP) nach einem der Ansprüche 6 oder 10, wobei die Steuermittel (CONT) dafür konfiguriert sind, an das Paar von entlang einer ersten Richtung benachbarten Pixeln, zum Beispiel an zwei Pixel derselben Spalte (Cⱼ), Folgendes anzulegen,
ein hohes Potential an die Übertragungsgatter (T3, T4), um ein Binning der elektrischen Ladungen auszuführen, die von der gemeinsamen Lesestufe (LECT_{i,j}) erzeugt werden.

12. Pixelmatrix (MP) nach einem der vorstehenden Ansprüche 1 bis 3, wobei jede Lesestufe (LECTᵢⱼ, LECT_{i,j+1}) Folgendes umfasst:
- einen Rücksetztransistor (T7), der an den Detektionsknoten angeschlossen ist, um den Detektionsknoten (SNᵢⱼ) auf eine ausgewählte Versorgungsspannung (VREF) zurückzusetzen;
- einen Verstärkungstransistor (T8), der in einem gemeinsamen Drain montiert ist, dessen Gatter an den Detektionsknoten (SNᵢⱼ) angeschlossen ist;
- einen Auswahltransistor (T9), der an den Ausgang des Verstärkungstransistor (T8) angeschlossen ist, um das Ausgangssignal abzutasten.

13. Bildsensor (IMG) umfassend:
- eine Pixelmatrix (MP) nach einem der vorstehenden Ansprüche,
- eine Schaltung zum Erzeugen der Steuersignale der Pixel (CONT),
- eine Abtastschaltung (B1), die an der Basis einer jeden Spalte der Pixelmatrix angeordnet ist, die an den Ausgang der Lesestufe eines jeden Pixels der entsprechenden Spalte angeschlossen ist,
- einen Versorgungsstromkreis (B2) zum Versorgen jeder Spalte der Pixelmatrix.

14. Bildsensor (IMG) nach Anspruch 13, wobei die Abtastschaltung (B1) eine Schaltung zum doppelten korrelierten Abtasten ist.

15. Bildsensor (IMG) nach einem der Ansprüche 13 oder 14, wobei der Sensor für einen Global-Shutter-Betrieb angepasst ist.

## Claims

1. A pixel matrix (MP) of N rows (Lᵢ) and M columns (Cⱼ) produced in a semiconductor substrate, the matrix comprising at least one sub-matrix (S) of four adjacent
pixels (Pxlᵢⱼ, Pxl₍ᵢ₊₁₎ⱼ, Pxlᵢ₍ⱼ₊₁₎, Pxl₍ᵢ₊₁₎₍ⱼ₊₁₎),
each of the pixels of the sub-matrix (S) comprising:
- a set of a photoelectric-effect element (EPE_{i,j}, EPE_{i+1,j}, EPE_{i,j+1}, EPE_{i+1,j+1}) for generating electric charges in response to incident electromagnetic radiation and a memory point (POINT_MEM_{i,j}, POINT_MEM_{i,j+1}, POINT_MEM_{i+1,j}, POINT_MEM_{i+1,j+1}) connected to the output of the photoelectric-effect element (EPEi,j, EPEi+1,j, EPEi,j+1, EPEi+1,j+1) for storing the generated electric charges;
- a detection node (SNᵢⱼ, SN_{i,j+1}),
- a transfer gate (T3, T5, T6, T4), connected between the output of the memory point (POINT_MEM_{i,j}, POINT_MEM_{i,j+1}, POINT_MEM_{i+1,j}, POINT_MEM_{i+1,j+1}) and the detection node (SNᵢⱼ, SN_{i,j+1}),
- a binning stage (SOM1, SOM2),
the binning stage being connected to said set and being common with an adjacent pixel (Pxl_{i,j+1}) of the sub-matrix (S) belonging to the same row (Lᵢ) of said pixel (Pxlᵢⱼ),
at least one detection node (SNᵢⱼ, SN_{i,j+1}) per sub-matrix (S) being common to two adjacent pixels (Pxlᵢⱼ, Pxl_{(i+1),j}) of the sub-matrix (S) belonging to the same column (Cⱼ),
the pixel matrix further comprising at least one readout stage (LECTᵢⱼ, LECT_{i,j+1}) per sub-matrix (S), connected to the common detection node (SNᵢⱼ, SN_{i,j+1});
the pixel matrix being **characterized in that** each of the memory points (POINT_MEM_{i,j}) is produced by an arrangement of two pairs of deep isolation trenches (dti3, dti4, dti5, dti6), the deep isolation trenches forming two electric charge confinements, the first confinement constituting the input of the memory point being formed by the first pair of trenches (dti3, dti4) arranged in parallel and separated by a first distance (d2), and the second confinement constituting the body of the memory point being formed by the second pair of trenches (dti5, dti6) arranged in parallel and separated by a second distance (d3);
the first distance being smaller than the second distance.

2. The pixel matrix (MP) according to claim 1, wherein each of the photoelectric-effect elements (EPE_{i,j}, EPE_{i+1,j}, EPE_{i,j+1}, EPE_{i+1,j+1}) is a pinned photodiode.

3. The pixel matrix (MP) according to any one of the preceding claims, wherein each of the binning stages (SOM1, SOM2) is produced by a pair of deep isolation trenches (dti1, dti2) arranged in parallel.

4. The pixel matrix (MP) according to any one of claims 1 to 3, wherein:
the binning stage (SOM1, SOM2) is connected between the output of the photoelectric-effect element (EPE_{i,j}) and the output of the photoelectric-effect element of the adjacent pixel of the sub-matrix (S) belonging to the same row,
the pixels (Pxlᵢⱼ, Pxl₍ᵢ₊₁₎ⱼ, Pxl₍ⱼ₊₁₎, Pxl₍ᵢ₊₁₎₍ⱼ₊₁₎) of the sub-matrix (S) belonging to the same column have a common detection node (SNᵢⱼ, SN_{i,j+1}) and a common readout stage (LECTᵢⱼ, LECT_{i,j+1}).

5. The pixel matrix (MP) according to claim 4, comprising control means (CONT) configured to apply (PH2), for each pixel of one and the same column Cⱼ:
- a high potential to the deep isolation trenches forming the memory point (POINT_MEM_{i,j}, POINT_MEM_{i+1,j}) for receiving the electric charges generated by the photoelectric-effect element (EPE_{i,j});
- a low potential to the deep isolation trenches forming the memory point (POINT_MEM_{i,j+1}, POINT_MEM_{i+1,j+1}) belonging to the adjacent pixel (Pxl_{i,j+1}) of the sub-matrix (S) belonging to the same row;
- a low potential to the deep isolation trenches forming the binning stage (SOM1).

6. The pixel matrix (MP) according to claim 5, wherein the control means (CONT) are configured to simultaneously apply (PH3), for each pixel of one and the same column (Cⱼ):
- a high potential to the deep isolation trenches forming the memory point (POINT_MEM_{i,j}, POINT_MEM_{i+1,j});
- a low potential to the deep isolation trenches forming the memory point (POINT_MEM_{i,j+1}, POINT_MEM_{i+1,j+1}) belonging to the adjacent pixel (Pxl_{i,j+1}) of the sub-matrix (S) belonging to the same row (Lᵢ);
- a high potential to the deep isolation trenches forming the binning stage (SOM1, SOM2),
to bin the electric charges generated by the pixels (Pxl_{i,j+1}, Pxl_{i,j+1}) belonging to one and the same row (Lᵢ, Lᵢ₊₁) of the sub-matrix (S).

7. The pixel matrix (MP) according to any one of claims 1 to 3, wherein:
the binning stage (SOM1, SOM2) of a pixel of the sub-matrix (S) is connected between the output of the memory point (POINT_MEM_{i,j}, POINT_MEM_{i,j+1}, POINT_MEM_{i+1,j}, POINT_MEM_{i+1,j+1}) and the output of the memory point of the pixel of the sub-matrix (S) belonging to the same row;
the pixels (Pxlᵢⱼ, Pxl_{(i+1),j}, Pxl_{i,(j+1)}, Pxl_{(i+1),(j+1)}) of the sub-matrix (S) belonging to the same column have a common detection node (SNᵢⱼ) and a common readout stage (LECTᵢⱼ).

8. The pixel matrix (MP) according to any one of claims 1 to 3, wherein:
the binning stage (SOM1, SOM2) of a pixel of the sub-matrix (S2) is connected between the output of the memory point (POINT_MEM_{i,j}, POINT_MEM_{i,j+1}, POINT_MEM_{i+1,j}, POINT_MEM_{i+1,j+1}) and the output of the memory point of the pixel of the sub-matrix (S2) belonging to the same row; a first pair of pixels (Pxl_{i+1,j}, Pxl_{i+1,j+1}) of the sub-matrix (S2) belonging to the same row share a common detection node (SNᵢⱼ) and a common readout stage (LECTᵢⱼ),
a second pair of pixels (Pxlᵢⱼ, Pxl_{i+1,j}) of a sub-matrix (S2) belonging to the same column are shared with an adjacent sub-matrix (S1),
the first pair of pixels (Pxli, j, Pxl i + 1, j + 1) of the adjacent sub-matrix (S1) being arranged on a different row from the first pair of pixels of the sub-matrix (S2).

9. The pixel matrix (MP) according to any one of claims 7 or 8, wherein the control means (CONT) are configured to apply (PH"2), for each pixel of the sub-matrix (S):
- a high potential to the deep isolation trenches forming the memory point (POINT_MEM_{i,j}, POINT_MEM_{i+1,j} POINT_MEM_{i,j+1}, POINT_MEM_{i+1,j+1}) for receiving the electric charges generated by the photoelectric-effect
elements (EPE_{i,j}, EPE_{i+1,j}, EPE_{i,j+1}, EPE_{i+1,j+1});
- a low potential to the deep isolation trenches forming the binning stages (SOM1, SOM2).

10. The pixel matrix (MP) according to claim 9, wherein the control means (CONT) are configured to simultaneously apply (PH"3), to a pair of adjacent pixels in a first direction:
- a high potential to the deep isolation trenches forming the memory point (POINT_MEM_{i,j}, POINT_MEM_{i+1,j});
- a low potential to the deep isolation trenches forming the memory point (POINT_MEM_{i,j+1}, POINT_MEM_{i+1,j+1}) belonging to the adjacent pixel (Pxl_{i,j+1}) of the sub-matrix (S) in a second direction different from the first direction;
- a high potential to the deep isolation trenches forming the binning stages (SOM1, SOM2);
to bin the electric charges generated by the adjacent pixels in the second direction.

11. The pixel matrix (MP) according to any one of claims 6 or 10, wherein the control means (CONT) are configured to apply, to the pair of adjacent pixels in a first direction, for example to two pixels of the same column (Cⱼ),
a high potential to the transfer gates (T3, T4) to bin the electric charges generated in the common readout stage (LECT_{i,j}).

12. The pixel matrix (MP) according to any one of the preceding claims, wherein each readout stage (LECTᵢⱼ, LECT_{i,j+1}) comprises:
- a reset transistor (T7) connected to the detection node to reset the detection node (SNᵢⱼ) to a chosen supply voltage (VREF);
- an amplification transistor (T8) installed in a common drain configuration, whose gate is connected to the detection node (SNᵢⱼ);
- a selection transistor (T9) connected to the output of the amplifier transistor (T8) to sample the output signal.

13. An image sensor (IMG) comprising:
- a pixel matrix (MP) according to any one of the preceding claims,
- a circuit for generating the control signals of the pixels (CONT),
- a sampling circuit (B1) arranged at the base of each column of the pixel matrix, connected to the output of the readout stage of each pixel of the corresponding column,
- a power supply circuit (B2) for supplying power to each column of the pixel matrix.

14. The image sensor (IMG) according to claim 13, wherein the sampling circuit (B1) is a correlated double sampling circuit.

15. The image sensor (IMG) according to any one of claims 13 or 14, the sensor being adapted for a global shutter operation.
